# EUROPEAN PATENT APPLICATION

(11) **EP 4 292 819 A1**
(43) Date of publication of application: **20.12.2023**
(21) Application number: 22752822.1
(22) Date of filing: 10.02.2022
(51) Int. Cl.: B41C 1/00, B41N 1/00, G03F 7/00, G03F 7/027, G03F 7/095, G03F 7/11

(54) **FLEXOGRAPHIC PRINTING PRECURSOR, FLEXOGRAPHIC PRINTING PLATE AND METHOD FOR MANUFACTURING FLEXOGRAPHIC PRINTING PLATE**

(30) Priority: 10.02.2021 JP 2021019889
(71) Applicant: Asahi Kasei Kabushiki Kaisha, Tokyo 1000006 (JP)
(72) Inventor: FUJIKI, Yuzo, Tokyo 100-0006 (JP); TOYOOKA, Sota, Tokyo 100-0006 (JP); MIYAMOTO, Shinji, Tokyo 100-0006 (JP); FURUKAWA, Masashi, Tokyo 100-0006 (JP)
(74) Representative: Strehl Schübel-Hopf & Partner
(86) International application number: PCT/JP2022/005383
(87) International publication number: WO 2022/173000

(57) **Abstract**

A flexographic printing raw plate including at least a support, a photosensitive resin composition layer, an ink absorbing layer, and an infrared ablation layer sequentially stacked, wherein the ink absorbing layer has a film thickness of 5 µm or more and 50 µm or less, the ink absorbing layer comprises polymer particles containing a butadiene skeleton and having a carboxyl group and/or a hydroxy group, and/or polymer particles obtained by polymerizing a monobasic or polybasic acid monomer, and a content of the polymer particles is 20% by mass or more and 95% by mass or less based on 100% by mass of the ink absorbing layer.

## Description

### Technical Field

The present invention relates to a flexographic printing raw plate, flexographic printing plate, and a manufacturing method of a flexographic printing plate.

### Background Art

Flexographic printing is one type of letterpress printing and is advantageously applicable to various printing objects as soft materials such as rubber and synthetic resin are used for flexographic printing plates. A method in which plate making is carried out using a negative film and a method involving use of computer to plate technology (hereinafter, CTP technology) in which information processed on a computer is directly drawn on a printing plate to produce relief are conventionally known as a manufacturing method of a flexographic printing plate used for flexographic printing. In the method using the CTP technology, a step of manufacturing a negative film is not needed, and costs and time required to manufacture a negative film are thus reduced. Therefore, the method involving use of CTP technology has become mainstream recently.

When CTP technology is used, a sheet in which a photosensitive resin composition layer, a protective layer (barrier layer), and an infrared ablation layer are stacked in sequence on a substrate made of, for example, PET resin is usually used as a raw plate of a flexographic printing plate (hereinafter, also referred to as a "flexographic printing raw plate").

Production of a flexographic printing plate by use of CTP technology is carried out in the following manner, for example. Firstly, a uniform cured layer is formed by performing back exposure in which the entire surface of a photosensitive resin composition layer is irradiated with ultraviolet light through a substrate of a film of PET resin or the like. Then, lithography is performed by irradiating, with a laser, an infrared ablation layer on the photosensitive resin composition layer to remove a part of the infrared ablation layer, thereby producing an image mask. Furthermore, relief exposure in which the photosensitive resin composition layer is irradiated with ultraviolet light through the image mask is performed to photocure the part at which the infrared ablation layer has been removed. Thereafter, the unexposed part (that is, the part not photocured) of the photosensitive resin composition layer is removed to form a relief image, which is a desired image, and a flexographic printing plate is thus obtained.

If oxygen exists at the time of performing relief exposure by irradiating a flexographic printing raw plate with ultraviolet light, oxygen radicals generated from oxygen inhibit photocuring reaction of a photosensitive resin composition, resulting in insufficient photocuring of the photosensitive resin composition layer.

Therefore, a technique for adjusting the shape of printing dots and a technique for forming a printing dot structure having a flat top and a precipitous shoulder are heretofore disclosed (see Patent Literature 1, for example), and in the latter, a mask layer capable of being laser-ablated is stacked on the photosensitive resin composition layer, followed by providing a barrier layer that blocks oxygen on the mask layer. The barrier layer is removed after light irradiation of the photosensitive resin composition layer.

Another technique is disclosed in which a water-soluble barrier layer is included in a flexographic printing raw plate for the purpose of blocking oxygen in the atmosphere and also protecting the surface of a photosensitive resin composition layer is disclosed (see Patent Literature 2, for example). The barrier layer is removed together with an uncured part of the photosensitive resin composition layer at the time of developing, and the barrier layer present on a photocured part of the photosensitive resin composition layer is also removed.

In any of the cases, the barrier layer is aimed at protecting a photosensitive resin composition and removed before use as a printing plate.

Flexographic printing plates are disadvantageously fated to cause a printed matter to be stained with ink accumulated in a relief concave part. Particularly, when printing is continued for a long time, ink often enters a concave part of a printing plate (hereinafter, also referred to as "plate surface stains") so that a part intrinsically having no pictorial pattern yields a print. Such a case is economically disadvantageous because printing needs to be temporarily discontinued to wipe the printing plate surface with a cloth or the like using a cleaning liquid such as an alcohol.

In view of improving such circumstances, it has been proposed that an organic silicon compound is contained in a photosensitive resin composition of a flexographic printing plate (see Patent Literature 3, for example). However, mere internal addition of an organic silicon compound to a photosensitive resin composition disadvantageously reduces the transparency of the photosensitive resin composition or reduces the capability of maintaining a shape even under heat or load applied to a construct during the course of storage or transportation (cold flow resistance). It is thus important to design an appropriate organic silicon compound.

However, if a photosensitive resin composition is designed such that ink is difficult to accumulate in a relief concave part, relief surface formed from such a resin composition is less likely to absorb ink, as a matter of course. In order to overcome this problem, a flexographic printing plate having a two-layer structure composed of a cap layer that absorbs ink and a composition layer that repels ink has been proposed in which a difference in surface tension between the two layers is 5 dynes/cm or more (see Patent Literature 4, for example).

### Citation List

### Patent Literature

Patent Literature 1: Japanese Translation of PCT International Application Publication No. 2014-507677
Patent Literature 2: Japanese Patent No. 5573675
Patent Literature 3: WO2007-116941
Patent Literature 4: Japanese Translation of PCT International Application Publication No. 2015-513700

### Summary of Invention

### Technical Problem

However, the flexographic printing plate described in Patent Literature 4 has a large difference in surface tension, and the photosensitive resin composition layer has too low a surface tension. Therefore, ink repelled from a concave part comes around to an ink absorbing part so that more than a necessary amount of ink is supplied thereto. As a result, so-called "tone jump" unfortunately occurs, and tone jump is a phenomenon in which the halftone of a highlighted part of a printed matter unintentionally becomes thicker than the desired size and lacks continuous change in tone (gradation) from dark color to light color to result in a discontinuous tone to thereby fail to properly express the gradation.

Therefore, giving consideration to the problems in conventional techniques, the present invention aims at providing a flexographic printing raw plate capable of producing a flexographic printing plate that has good ink adhesion properties without thickening the halftone of a highlight area and is thus excellent in printing characteristics, a flexographic printing plate, and a manufacturing method thereof.

### Solution to Problem

The present inventors have made intensive studies to solve the above-described problems, and as a result, found that the problems can be solved by forming an ink absorbing layer having a predetermined film thickness; thus, the present invention has been accomplished.

Specifically, the present invention is as follows.
[1] A flexographic printing raw plate comprising at least a support, a photosensitive resin composition layer, an ink absorbing layer, and an infrared ablation layer sequentially stacked, wherein
   the ink absorbing layer has a film thickness of 5 µm or more and 50 µm or less,
   the ink absorbing layer comprises polymer particles containing a butadiene skeleton and having a carboxyl group and/or a hydroxy group, and/or polymer particles obtained by polymerizing a monobasic or polybasic acid monomer, and
   a content of the polymer particles is 20% by mass or more and 95% by mass or less based on 100% by mass of the ink absorbing layer.
[2] The flexographic printing raw plate according to [1], wherein
   the ink absorbing layer further comprises a binder resin having a basic group.
[3] The flexographic printing raw plate according to [2], wherein
   the binder resin having a basic group comprises polyamide resin and/or polyurethane resin.
[4] The flexographic printing raw plate according to any one of [1] to [3], wherein
   the ink absorbing layer further comprises polyvinyl alcohol resin.
[5] The flexographic printing raw plate according to any one of [1] to [4], wherein
   the ink absorbing layer further comprises swellable mica.
[6] The flexographic printing raw plate according to any one of [1] to [5], wherein
   the ink absorbing layer further comprises a water-soluble photopolymerization initiator and a water-soluble polymerizable compound.
[7] The flexographic printing raw plate according to [6], wherein
   the water-soluble polymerizable compound has an amide skeleton and/or a urethane skeleton.
[8] The flexographic printing raw plate according to any one of [1] to [7], wherein
   the ink absorbing layer further comprises a water-soluble resin having an alkylene oxide chain.
[9] A flexographic printing plate comprising at least a support, a photocured photosensitive resin composition layer, and an ink absorbing layer sequentially stacked, wherein
   the ink absorbing layer has a film thickness of 5 µm or more and 50 µm or less, and
   the ink absorbing layer comprises polymer particles containing a butadiene skeleton and having a carboxyl group and/or a hydroxy group, and/or polymer particles obtained by polymerizing a monobasic or polybasic acid monomer.
[10] The flexographic printing plate according to [9], wherein
   a difference between surface free energy of the ink absorbing layer, Ei, and surface free energy of the photocured photosensitive resin composition layer, Ep, (Ei - Ep) is larger than 0 mJ/m² and 5 mJ/m² or less.
[11] The flexographic printing plate according to [10], wherein
   the difference between surface free energy of the ink absorbing layer, Ei, and surface free energy of the photocured photosensitive resin composition layer, Ep, (Ei - Ep) is larger than 0 mJ/m² and 4 mJ/m² or less.
[12] The flexographic printing plate according to [10], wherein
   the difference between surface free energy of the ink absorbing layer, Ei, and surface free energy of the photocured photosensitive resin composition layer, Ep, (Ei - Ep) is larger than 0.5 mJ/m² and 3.5 mJ/m² or less.
[13] The flexographic printing plate according to any one of [9] to [12], wherein
   the ink absorbing layer further comprises a water-soluble polymer having an alkylene oxide chain.
[14] The flexographic printing plate according to any one of [9] to [13], wherein
   a content of the polymer particles is 20% by mass or more and 95% by mass or less based on 100% by mass of the ink absorbing layer.
[15] The flexographic printing plate according to any one of [9] to [14], wherein
   a membrane zeta potential of the ink absorbing layer is a positive value.
[16] The flexographic printing plate according to any one of [9] to [15], wherein
   the ink absorbing layer further comprises a binder resin having a basic group.
[17] The flexographic printing plate according to [16], wherein
   the binder resin having a basic group comprises polyamide resin and/or polyurethane resin.
[18] The flexographic printing plate according to any one of [9] to [17], wherein
   the ink absorbing layer further comprises polyvinyl alcohol resin.
[19] The flexographic printing plate according to any one of [9] to [18], wherein
   the ink absorbing layer further comprises swellable mica.
[20] The flexographic printing plate according to any one of [9] to [19], wherein
   the ink absorbing layer further comprises a water-soluble photopolymerization initiator and a water-soluble polymerizable compound.
[21] The flexographic printing plate according to [20], wherein
   the water-soluble polymerizable compound has an amide skeleton and/or a urethane skeleton.
[22] A manufacturing method of a flexographic printing plate, comprising:
   a step of producing a negative pattern by subjecting the infrared ablation layer of the flexographic printing raw plate according to any one of [1] to [8] to laser ablation;
   a step of exposing the photosensitive resin composition layer through the ink absorbing layer; and
   a step of removing an unexposed part of the photosensitive resin composition layer and the ink absorbing layer.

### Advantageous Effects of Invention

According to the present invention, a flexographic printing raw plate capable of producing a flexographic printing plate that has good ink adhesion properties without thickening the halftone of a highlight area and is thus excellent in printing characteristics, a flexographic printing plate, and a manufacturing method thereof can be provided.

### Brief Description of Drawings

[Figure 1] Figure 1 is a schematic cross-sectional view of the flexographic printing raw plate of the present embodiment.
[Figure 2] Figure 2 is a schematic view showing one form of a manufacturing method of a flexographic printing plate using the flexographic printing raw plate of the present embodiment.
[Figure 3] Figure 3 is a schematic view showing another form of a manufacturing method of a flexographic printing plate using the flexographic printing raw plate of the present embodiment.
[Figure 4] Figure 4 is a schematic view for illustrating ink adhesion properties.
[Figure 5] Figure 5 is a schematic cross-sectional view of a flexographic printing plate obtained by using the flexographic printing raw plate of the present embodiment.

### Description of Embodiment

Hereinafter, a mode for carrying out the present invention (hereinafter, referred to as the "present embodiment") will be described in detail. However, the present invention is not limited thereto, and various modifications can be made without departing from the spirit of the present invention.

### 1. Flexographic printing raw plate

The flexographic printing raw plate of the present embodiment includes at least a support, a photosensitive resin composition layer, an ink absorbing layer, and an infrared ablation layer sequentially stacked, in which the ink absorbing layer has a film thickness of 5 µm or more and 50 µm or less, the ink absorbing layer includes, as polymer particles (a-2), (a-2-1) polymer particles containing a butadiene skeleton and having a carboxyl group and/or a hydroxy group, and/or (a-2-2) polymer particles obtained by polymerizing a monobasic or polybasic acid monomer, and a content of the polymer particles (a-2) is 20% by mass or more and 95% by mass or less based on 100% by mass of the ink absorbing layer.

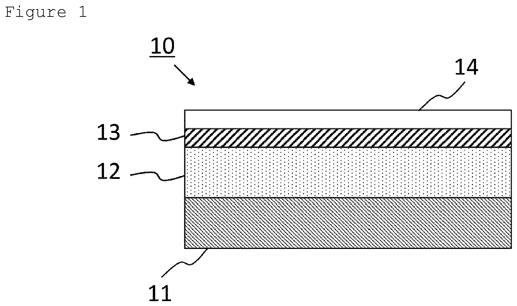

Figure 1 shows a schematic cross-sectional view of the flexographic printing raw plate of the present embodiment. In flexographic printing raw plate 10 of the present embodiment, support 11, photosensitive resin composition layer 12 on which a concave-convex pattern of a flexographic printing plate is formed, ink absorbing layer 13 which is placed on the top of a concave-convex pattern of a flexographic printing plate, and infrared ablation layer 14 which functions as a mask at the time of forming a concave-convex pattern of a flexographic printing plate are sequentially stacked. A functional layer such as an adhesive layer may be provided between these layers as needed. Hereinafter, the configuration of the flexographic printing raw plate of the present embodiment will be described in detail.

### 1.1. Support

The support used for the flexographic printing raw plate of the present embodiment is not particularly limited, and examples thereof include a polypropylene film, a polyethylene film, a film of a polyester such as polyethylene terephthalate and polyethylene naphthalate, and a polyamide film. Among them, a polyester film is preferable as the support.

The thickness of the support is preferably 75 µm to 300 µm.

In addition, an adhesive layer may be provided between the support and the photosensitive resin composition layer for the purpose of increasing adhesive strength between the support and the photosensitive resin composition layer.

The material for the adhesive layer is not particularly limited, and examples thereof include a composition having a binder polymer such as polyurethane, polyamide, and a thermoplastic elastomer and an adhesive active ingredient such as an isocyanate compound and an ethylenically unsaturated compound.

Furthermore, various auxiliary additive components such as a plasticizer, a thermal-polymerization preventing agent, an ultraviolet absorber, a halation preventing agent, a photostabilizer, a photopolymerization initiator, a photopolymerizable monomer, and a dye can be added to the adhesive layer.

At least one or more undercoating layers may be provided between the adhesive layer and the support for the purpose of further increasing adhesive strength between the adhesive layer and the support.

### 1.2. Photosensitive resin composition layer

The flexographic printing raw plate of the present embodiment has a photosensitive resin composition layer on the support. Preferable examples of material for the photosensitive resin composition layer include a photosensitive resin composition including a thermoplastic elastomer (a-1), polymer particles (a-2), a photopolymerizable monomer (a-3), and a photopolymerization initiator (a-4). In addition to these major components, the photosensitive resin composition layer may optionally include a liquid diene (a-5) and silicone compound (a-6) and others. These components (a-1) to (a-6) will be described below in detail. Those described in "Japanese Patent Laid-Open No. 2018-120131" can be used as these compounds, for example.

### 1.2.1. Thermoplastic elastomer (a-1)

The thermoplastic elastomer( a-1) is not particularly limited, and examples thereof include a thermoplastic elastomer having a constituent unit derived from conjugated diene and/or vinyl aromatic hydrocarbon. The thermoplastic elastomer may be a homopolymer or a copolymer. In the case of a copolymer, the thermoplastic elastomer may be a random copolymer or a block copolymer.

Among them, a thermoplastic elastomer containing at least one polymer block including mainly a conjugated diene and at least one polymer block including mainly a vinyl aromatic hydrocarbon is preferable.

The term "including mainly" used herein means that 60% by mass or more of the polymer block is constituted by a predetermined monomer.

In the polymer block including mainly a conjugated diene, the content of the conjugated diene unit is preferably 80% by mass or more and more preferably 90% by mass or more of the polymer block.

The conjugated diene is not particularly limited, and examples thereof include monomers such as 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene. Among them, 1,3-butadiene is especially preferable in view of abrasion resistance. These monomers may be used singly or in combinations of two or more thereof.

A vinyl content in the polymer block including mainly the conjugated diene is preferably 5 to 50 mol%, more preferably 8 to 50 mol%, and still more preferably 10 to 40 mol% based on the total amount of the conjugated diene unit in view of printing plate formability. The "vinyl content" herein refers to a content of 1,2-butadiene or 3,4-isoprene, for example.

A number average molecular weight of the polymer block including mainly the conjugated diene is preferably 20,000 to 250,000, more preferably 30,000 to 200,000, and still more preferably 40,000 to 150,000 in view of wear resistance of the plate.

The polymer block including mainly the conjugated diene may contain an alkylene unit. An introducing method of the alkylene unit is not particularly limited, and examples thereof include a method involving polymerization using a monoolefin such as ethylene and butylene as a starting material monomer of the polymer block including mainly the conjugated diene, and a method involving hydrogenating conjugated diene polymer block. Especially, a method involving hydrogenating polymer block including mainly the conjugated diene is preferable in view of availability.

The content of the alkylene unit in the polymer block including mainly the conjugated diene is preferably 5 to 50 mol%, more preferably 10 to 35 mol%, and still more preferably 10 to 25 mol% based on the total amount of monomer units included in the polymer block. When the content of the alkylene unit is 5 mol% or more, solvent resistance tends to more improve. When the content of the alkylene unit is 50 mol% or less, transparency of the photosensitive resin composition layer tends to more improve.

The polymer block including mainly conjugated diene preferably contains an alkylene unit and more preferably all of a 1,4-butadiene unit, a 1,2-butadiene (vinyl) unit, and a butylene (alkylene) unit. In this respect, it is further preferable that the polymer block including mainly conjugated diene contain 25 to 70 mol% of a 1,4-butadiene unit, 0 to 50 mol% of a 1,2-butadiene (vinyl) unit, and 10 to 50 mol% of a butylene unit. Such a polymer block can be obtained by hydrogenating the polymer block moiety including mainly butadiene.

The conjugated diene content, the vinyl content in the conjugated diene, and the content and ratio of the vinyl aromatic hydrocarbon can be measured using a nuclear magnetic resonance device (¹H-NMR).

The vinyl aromatic hydrocarbon is not particularly limited, and examples thereof include monomers such as styrene, t-butylstyrene, divinylbenzene, 1,1-diphenylstyrene, N,N-dimethyl-p-aminoethyl styrene, N,N-diethyl-p-aminoethyl styrene, vinylpyridine, p-methylstyrene, tertiary butylstyrene, α-methylstyrene, and 1,1-diphenylethylene. Especially, styrene is preferable because a flexographic printing raw plate with smoothness can be formed at a relatively low temperature (hereinafter, also referred to as "high smoothness"). These monomers may be used singly, or in combinations of two or more thereof.

A number average molecular weight of the polymer block including mainly the vinyl aromatic hydrocarbon is preferably 100,000 or less in view of preventing orientation of a printing plate from being exhibited and is preferably 3,000 or more in view of chipping resistance during plate making and printing. The number average molecular weight of the polymer block including mainly the vinyl aromatic hydrocarbon is more preferably 5,000 to 80,000 and still more preferably 5,000 to 60,000.

The content of the vinyl aromatic hydrocarbon in the block copolymer is preferably 13 to 25% by mass, more preferably 15 to 24% by mass, and still more preferably 16 to 23% by mass based on the total amount of the block copolymer. When the content of the vinyl aromatic hydrocarbon is 25% by mass or less, high smoothness of the photosensitive resin composition, high chipping resistance at a convex part of the printing plate, and hardness of the printing plate kept high when an ink component attaches thereto tend to be attained. On the other hand, when the content of the vinyl aromatic hydrocarbon is 13% by mass or more, cold flow resistance of the flexographic printing raw plate tends to more improve.

The content of the thermoplastic elastomer (a-1) in the photosensitive resin composition layer is preferably 15 to 90% by mass, more preferably 15 to 80% by mass and still more preferably 20 to 75% by mass based on 100% by mass of the total amount of the photosensitive resin composition in view of wear resistance of the plate during printing.

### 1.2.2. Polymer particles (a-2)

The polymer particles (a-2) are internally-crosslinked polymer particles of a monomer. Such polymer particles are not particularly limited, and examples thereof include those obtained by preparing a water-dispersion latex in which polymer particles as a dispersoid are dispersed in water by emulsion polymerization, and removing water from the obtained water-dispersion latex.

The monomer that constitutes the polymer particles (a-2) is not particularly limited as long as it has a polymerizable double bond. Examples thereof include monobasic acid monomers, polybasic acid monomers, conjugated dienes, aromatic vinyl compounds, (meth)acrylic acid esters, monomers having a hydroxy group, unsaturated dibasic acid alkyl esters, maleic anhydride, vinyl cyanide compounds, (meth)acrylamides and derivatives thereof, vinyl esters, vinyl ethers, vinyl halides, basic monomers having an amino group, vinylpyridine, olefins, silicon-containing α,β-ethylenically unsaturated monomers, and allyl compounds. The monomer that constitutes the polymer particles (a-2) may include a reactive emulsifier for use in emulsion polymerization described later.

The monobasic acid monomers are not particularly limited, and examples thereof include monomers having a carboxyl group, such as acrylic acid, methacrylic acid, crotonic acid, vinylbenzoic acid, and cinnamic acid; and monomers having a sulfonic acid group, such as styrenesulfonic acid.

The content of the monobasic acid monomer is preferably 1 to 30% by mass, more preferably 2 to 20% by mass, still more preferably 3 to 15% by mass, and further preferably 5 to 10% by mass based on the total amount of the polymer particles (a-2).

The polybasic acid monomers are not particularly limited, and examples thereof include monomers having two or more carboxyl groups, such as itaconic acid, fumaric acid, maleic acid, citraconic acid, and muconic acid; and monomers having a polybasic acid group of a phosphoric acid group.

The conjugated dienes are not particularly limited, and examples thereof include 1,3-butadiene, isoprene, 2,3-dimethyl-1,3-butadiene, 2-ethyl-1,3-butadiene, 2-methyl-1,3-butadiene, 1,3-pentadiene, chloroprene, 2-chloro-1,3-butadiene, and cyclopentadiene.

The content of the conjugated diene is preferably 45 to 75% by mass, more preferably 50 to 70% by mass, and still more preferably 55 to 65% by mass based on the total amount of the polymer particles (a-2).

The aromatic vinyl compounds are not particularly limited, and examples thereof include styrene, α-methylstyrene, o-methylstyrene, m-methylstyrene, p-methylstyrene, ethylstyrene, vinyltoluene, vinylxylene, bromostyrene, vinylbenzyl chloride, p-t-butylstyrene, chrolostyrene, alkylstyrene, divinylbenzene, and trivinylbenzene.

The content of the aromatic vinyl compound is preferably 3 to 25% by mass, more preferably 5 to 20% by mass, and still more preferably 7.5 to 15% by mass based on the total amount of the polymer particles (a-2).

Examples of the (meth)acrylic acid esters include, but not particularly limited to, methyl (meth)acrylate, ethyl (meth)acrylate, propyl (meth)acrylate, n-butyl (meth)acrylate, t-butyl (meth)acrylate, isobutyl (meth)acrylate, n-amyl (meth)acrylate, isoamylhexyl (meth)acrylate, octyl (meth)acrylate, nonyl (meth)acrylate, decyl (meth)acrylate, dodecyl (meth)acrylate, octadecyl (meth)acrylate, cyclohexyl (meth)acrylate, phenyl (meth)acrylate, benzyl (meth)acrylate, 2-ethyl-hexyl (meth)acrylate, glycidyl (meth)acrylate, ethylene glycol di(meth)acrylate, ethylene glycol di(meth)acrylate, 1,3-butylene glycol di(meth)acrylate, 1,4-butylene glycol di(meth)acrylate, propylene glycol di(meth)acrylate, 1,5-pentanediol di(meth)acrylate, neopentyl glycol di(meth)acrylate, 1,6-hexanediol di(meth)acrylate, diethylene glycol di(meth)acrylate, triethylene glycol di(meth)acrylate, tetraethylene glycol di(meth)acrylate, polyethylene glycol di(meth)acrylate, polypropylene glycol di(meth)acrylate, pentaerythritol tri(meth)acrylate, trimethylolpropane tri(meth)acrylate, tetramethylolmethane tetra(meth)acrylate, allyl (meth)acrylate, bis(4-acryloxypolyethoxyphenyl)propane, methoxy polyethylene glycol (meth)acrylate, β-(meth)acryloyloxy ethylhydrogenphthalate, β-(meth)acryloyloxy ethylhydrogensuccinate, 3-chloro-2-hydroxypropyl (meth)acrylate, stearyl (meth)acrylate, phenoxyethyl (meth)acrylate, phenoxypolyethyleneglycol (meth)acrylate, 2-hydroxy-1,3-di(meth)acryloxypropane, 2,2-bis[4-((meth)acryloxyethoxy)phenyl]propane, 2,2-bis[4-((meth)acryloxy-diethoxy)phenyl]propane, 2,2-bis[4-((meth)acryloxy-polyethoxy)phenyl]propane, and isobornyl (meth)acrylate.

The content of the (meth)acrylic acid ester is preferably 10 to 35% by mass, more preferably 15 to 30% by mass, and still more preferably 20 to 25% by mass based on the total amount of the polymer particles (a-2).

The monomers having a hydroxy group are not particularly limited, and examples thereof include ethylene-based monocarboxylic acid alkyl ester monomers such as 2-hydroxyethyl acrylate, 2-hydroxyethyl methacrylate, 2-hydroxypropyl acrylate, 2-hydroxypropyl methacrylate, 1-hydroxypropyl acrylate, 1-hydroxypropyl methacrylate, and hydroxycyclohexyl (meth)acrylate.

Examples of the unsaturated dibasic acid alkyl esters include, but not particularly limited to, alkyl crotonates, alkyl itaconates, alkyl fumarates, and alkyl maleates.

Examples of the vinyl cyanide compounds include, but not particularly limited to, acrylonitrile and methacrylonitrile.

Examples of the (meth)acrylamides and derivatives thereof include, but not particularly limited to, (meth)acrylamide, N-methylol (meth)acrylamide, and N-alkoxy (meth)acrylamide.

Examples of the vinyl esters include, but not particularly limited to, vinyl acetate, vinyl butyrate, vinyl stearate, vinyl laurate, vinyl myristate, vinyl propionate, and vinyl ester of versatic acid.

Examples of the vinyl ethers include, but not particularly limited to, methyl vinyl ether, ethyl vinyl ether, propyl vinyl ether, butyl vinyl ether, amyl vinyl ether, and hexyl vinyl ether.

Examples of the vinyl halides include, but not particularly limited to, vinyl chloride, vinyl bromide, vinyl fluoride, vinylidene chloride, and vinylidene fluoride.

Examples of the basic monomers having an amino group include, but not particularly limited to, aminoethyl (meth)acrylate, dimethylaminoethyl (meth)acrylate, and diethylaminoethyl (meth)acrylate.

Examples of the olefins include, but not particularly limited to, ethylene.

Examples of the silicon-containing α,β-ethylenically unsaturated monomers include, but not particularly limited to, vinyltrichlorosilane and vinyltriethoxysilane.

Examples of the allyl compounds include, but not particularly limited to, allyl esters and diallyl phthalates.

Besides, a monomer having three or more double bonds such as triallyl isocyanurate can be also used.

These monomers may be used singly, or two or more thereof may be mixed and used. In particular, it is preferable to include a monomer having an acidic group (hereinafter, also simply referred to as an "acidic monomer") such as a monobasic acid monomer or a polybasic acid monomer, and a monomer having a hydrophobic group (hereinafter, also simply referred to as a "hydrophobic monomer") such as conjugated diene, an aromatic vinyl compound, or a (meth)acrylic acid ester. The conjugated diene, the aromatic vinyl compound, and the (meth)acrylic acid ester that correspond to the hydrophobic monomer have a hydrocarbon group, and those having a hydrophilic group such as a hydroxy group are excluded from the hydrophobic monomer even if they are a (meth)acrylic acid ester or the like.

The content of the acidic monomer is preferably 1 to 30% by mass, more preferably 2 to 20% by mass, still more preferably 3 to 15% by mass, and further preferably 5 to 10% by mass based on the total amount of the polymer particles (a-2). When the content of the acidic monomer is 1% by mass or more, aqueous developing performance tends to more improve. When the content is 30% by mass or less, an increase in the amount of moisture absorbed by the photosensitive resin composition and an increase in swelling by ink can be prevented, and deterioration in processability during mixing the photosensitive resin composition can be prevented.

The content of the monomer having a hydrophobic group is preferably 70 to 99% by mass, more preferably 80 to 98% by mass, still more preferably 85 to 97% by mass, and further preferably 90 to 95% by mass. When the polymer particles (a-2) has such composition, rubber elasticity of the photosensitive resin composition tends to more improve.

The polymer included in the polymer particles (a-2) is not particularly limited, and examples thereof include polymers having a butadiene skeleton, such as polybutadiene, an acrylonitrile-butadiene copolymer, a styrene-butadiene copolymer, and a (meth)acrylate-butadiene copolymer; polymers having an isoprene skeleton, such as polyisoprene and polychloroprene; polymers obtained by further polymerizing a monomer having a carboxyl group and/or a hydroxy group with the polymers having butadiene skeleton or an isoprene skeleton; polymers obtained by further polymerizing a (meth)acrylic acid ester with the polymers having butadiene skeleton or an isoprene skeleton; polymers obtained by further polymerizing a (meth)acrylic acid ester and a monomer having a carboxyl group and/or a hydroxy group with the polymers having butadiene skeleton or an isoprene skeleton; and polyurethane, a vinylpyridine polymer, a butyl polymer, a Thiokol polymer, an acrylate polymer, and natural rubber.

The monomer having a carboxyl group herein means the monobasic acid monomer and/or the polybasic acid monomer.

Among them, a polymer having a butadiene skeleton, a polymer having an isoprene skeleton, and a polymer obtained by further polymerizing a (meth)acrylic acid ester and/or a monomer having a carboxyl group and/or a hydroxy group with the polymer having a butadiene skeleton or an isoprene skeleton are preferable, and a polymer obtained by further polymerizing a (meth)acrylic acid ester and/or a monomer having a carboxyl group and/or a hydroxy group with the polymer having a butadiene skeleton is more preferable. The polymer particles (a-2) may be used singly or in combinations of two or more thereof.

Among those described above, (a-2-1) polymer particles containing a butadiene skeleton and having a carboxyl group and/or a hydroxy group, and (a-2-2) polymer particles obtained by polymerizing a monobasic or polybasic acid monomer are more preferable. When such polymer particles (a-2) are used, adhesion between the ink absorbing layer and the photosensitive resin composition layer tends to more improve during the course of developing.

The average particle diameter of the polymer particles (a-2) is preferably 500 nm or less and more preferably 100 nm or less. When the average particle diameter is 500 nm or less, aqueous developing performance of the flexographic printing raw plate tends to more improve.

The toluene gel fraction of the polymer particles (a-2) is preferably 60% to 99%. When the toluene gel fraction is 60% or more, practically sufficient strength tends to be imparted to a printing plate to be obtained. When the toluene gel fraction is 99% or less, mixing properties between the polymer particles (a-2) and the thermoplastic elastomer (a-1) tend to be good.

The toluene gel fraction herein is a mass fraction (%) obtained as follows. An appropriate amount of a dispersion containing about 30% by mass of the polymer particles (a-2) is dropped on a Teflon (R) sheet followed by drying at 130°C for 30 minutes; 0.5 g of the polymer particles (a-2) is taken therefrom and immersed in 30 mL of toluene at 25°C followed by shaking for three hours using a shaking device and subsequent filtration with a 320 SUS mesh; the matter not passing through the mesh is dried at 130°C for one hour; and the mass of the dried matter is divided by 0.5 (g).

The content of the polymer particles (a-2) is preferably 10 to 70% by mass, more preferably 15 to 60% by mass, and still more preferably 20 to 50% by mass based on 100% by mass of the total amount of the photosensitive resin composition in view of developing performance at the time of producing a printing plate.

### (Manufacturing method of polymer particles (a-2))

A synthesis method of the polymer particles (a-2) is not particularly limited, and a polymer synthesized through emulsion polymerization is preferable, for example. Examples of the emulsion polymerization method of the polymer particles (a-2) include a method in which predetermined amounts of water, an emulsifier, and other additives are fed, in advance, to a reaction system having been adjusted to a temperature at which polymerization is possible, and a polymerization initiator and a monomer, an emulsifier, an adjuster, and the like are added into this reaction system by batch operation or continuous operation. In addition, predetermined amounts of a seed latex, a polymerization initiator, a monomer, and another adjuster may be added in advance to the emulsion polymerization reaction system.

The layer structure of polymer particles to be synthesized can also be changed stepwise by devising a method of adding the monomer, emulsifier, other additives, and adjuster to the reaction system. In this case, physical properties representing the structure of each layer include hydrophilicity, glass transition temperature, molecular weight, crosslinking density. The number of layers in this layer structure is not particularly limited.

Hereinafter, each component other than the already mentioned monomer will be described.

The emulsifier (surfactant) used at the time of emulsion polymerization is not particularly limited, and examples thereof include a reactive emulsifier and/or a non-reactive emulsifier. Among them, a reactive emulsifier is preferably used.

The reactive emulsifier is preferably a reactive emulsifier including a radically polymerizable double bond, a hydrophilic functional group, and a hydrophobic group in its molecular structure and having emulsifying, dispersing, and swelling functions as with common emulsifiers. Among them, a preferable reactive emulsifier (surfactant) is such that the reactive emulsifier is capable of providing a polymer particles having an average particle diameter of 5 to 500 nm when the reactive emulsifier is used in an amount of 0.1 parts by mass or more per 100 parts by mass of all monomers but the reactive emulsifier.

The hydrophilic functional group of the reactive emulsifier is not particularly limited, and examples thereof include anionic groups such as a sulfate group, a nitrate group, a phosphate group, a borate group, and a carboxy group; cationic groups such as an amino group; polyoxyalkylene chain structure or the like such as polyoxyethylene, polyoxymethylene, and polyoxypropylene; or hydroxy group. The reactive emulsifier can be classified into an anionic emulsifier, a nonionic emulsifier, a cationic emulsifier, or an amphoteric emulsifier, according to the type of the hydrophilic functional group.

The hydrophobic group of the reactive emulsifier is not particularly limited, and examples thereof include an alkyl group and a phenyl group. The radically polymerizable double bond of the reactive emulsifier is not particularly limited, and examples thereof include a vinyl group and an acryloyl group or a methacryloyl group. The radically polymerizable double bond, the hydrophilic functional group, and the hydrophobic group may each be included in the molecular structure in a combination of several types.

The commercially available surfactant can be used as the reactive emulsifier. The commercially available anionic surfactant is not particularly limited, and examples thereof include ADEKA REASOAP SE (manufactured by ADEKA Corporation), Aqualon HS, BC, and KH (manufactured by DKS Co. Ltd.), LATEMUL S (manufactured by Kao Corporation), Antox MS (manufactured by Nippon Nyukazai Co., Ltd.), ADEKA REASOAP SDX and PP (manufactured by ADEKA Corporation), Hightenol A (manufactured by DKS Co. Ltd.), ELEMINOL RS (manufactured by Sanyo Chemical Industries, Ltd.), and SPINOMAR (manufactured by Toyo Soda Kogyo Kabushiki Kaisha). The commercially available nonionic surfactant is not particularly limited, and examples thereof include Aqualon RN and Noigen N (manufactured by DKS Co. Ltd.) and ADEKA REASOAP NE (manufactured by ADEKA Corporation). These may be used singly, or two or more thereof may be used in combination.

The amount of the reactive emulsifier used is preferably 1 to 20 parts by mass per 100 parts by mass of the polymer particles (a-2) calculated from the amount of starting materials fed. When the amount of the reactive emulsifier is 1 part by mass or more, image reproducibility of a printing plate obtained tends to improve. When the amount of the reactive emulsifier is 20 parts by mass or less, wear resistance of the printing plate obtained tends to improve.

Examples of the non-reactive emulsifier include, but not particularly limited to, anionic surfactants such as fatty acid soap, rosin acid soap, a sulfonate, a sulfate, a phosphate, a polyphosphate, and an acyl sarcosinate; cationic surfactants such as a nitrilated fat or oil derivative, a fat or oil derivative, a fatty acid derivative, and an α-olefin derivative; and nonionic surfactants such as an alcohol ethoxylate, an alkylphenol ethoxylate, a propoxylate, a fatty acid alkanolamide, an alkyl polyglycoside, a polyoxyethylene sorbitan fatty acid ester, and an oxyethylene oxypropylene block copolymer. These may be used singly, or two or more thereof may be used in combination.

Examples of the above-described sulfonate include, but not particularly limited to, an alkyl sulfonate, an alkyl sulfate, an alkyl sulfosuccinate, a polyoxyethylene alkyl sulfate, sulfonated fat or oil, an alkyldiphenylether disulfonate, an α-olefin sulfonate, an alkyl glyceryl ether sulfonate, and an N-acylmethyltaurate. Examples of the non-reactive emulsifier other than those described above include, but are not particularly limited to, those described in "Kaimenkasseizai handobukku (Surfactant Handbook) (Takahashi, Namba, Koike, Kobayashi: Kougakutosho Ltd., 1972)".

The amount of the non-reactive emulsifier used is preferably less than 1 part by mass per 100 parts by mass of the polymer particles (a-2) calculated from an amount of starting material fed. When the amount of the non-reactive emulsifier used is less than 1 part by mass, a printing plate to be obtained has an appropriate water swelling ratio, and a decrease of abrasion resistance occurring when ink attaches and a decrease of image reproducibility after absorbing moisture can be thus prevented.

The polymerization initiator is not particularly limited, and examples thereof include a radical polymerization initiator. The radical polymerization initiator is not particularly limited and is, for example, radically decomposed under the presence of heat or a reducing substance to initiate addition polymerization of monomers, and both of an inorganic initiator and an organic initiator can be used.

The radical polymerization initiator is not particularly limited, and examples thereof include a water-soluble or oil-soluble peroxodisulfate, a peroxide, and an azobis compound, and specific examples thereof include potassium peroxodisulfate, sodium peroxodisulfate, ammonium peroxodisulfate, hydrogen peroxide, t-butyl hydroperoxide, benzoyl peroxide, 2,2-azobis butyronitrile, and cumene hydroperoxide. Compounds described in POLYMER HANDBOOK (3rd edition), written by J. Brandup and E.H. Immergut, published by John Willy & Sons, (1989) can also be used as the radical polymerization initiator. A so-called redox polymerization method, in which a reducing agent such as sodium acidic sulfite, ascorbic acid or a salt thereof, erythorbic acid and a salt thereof, or Rongalit is used in combination with a polymerization initiator, can also be employed. Among them, peroxodisulfate is preferable as the polymerization initiator.

The amount of the polymerization initiator used is usually 0.1% to 5.0% by mass and is preferably 0.2 to 3.0% by mass based on the total amount of monomers used for polymerization of the polymer particles (a-2). When the amount of the polymerization initiator used is 0.1% by mass or more, high stability can be obtained at the time of synthesizing the polymer particles (a-2). When the amount of the polymerization initiator used is 5.0% by mass or less, the amount of moisture absorbed by the photosensitive resin composition can be reduced so as to fall within a practically preferable range.

A known chain transfer agent can be used in the polymerization process of the polymer particles (a-2). A chain transfer agent including sulfur can be preferably used as the chain transfer agent. Examples of the chain transfer agent including sulfur include, but not particularly limited to, an alkanethiol such as t-dodecyl mercaptan and n-dodecyl mercaptan; a thioalkyl alcohol such as mercaptoethanol and mercaptopropanol; a thioalkyl carboxylic acid such as thioglycolic acid and thiopropionic acid; an alkyl thiocarboxylate acid such as octyl thioglycolate and octyl thiopropionate; and a sulfide such as dimethyl sulfide and diethyl sulfide.

Examples of the other chain transfer agents include, but not particularly limited to, terpinolene, dipentene, t-terpinene, and a hydrocarbon halide such as carbon tetrachloride. Among these chain transfer agents, alkanethiols are preferable because they have large chain transfer rates and give polymerization products having well-balanced physical properties. These chain transfer agents may be used singly, or two or more thereof may be used in combination.

These chain transfer agents are mixed to monomers and then supplied to a reaction system or independently added in a predetermined amount at a predetermined time. The amount of these chain transfer agents used is preferably 0.1% to 10% by mass based on the total amount of monomers used for polymerization of the polymer particles (a-2). The amount of 0.1% by mass or more provides good processability at the time of mixing the photosensitive resin composition, and the amount of 10% by mass or less enables the molecular weight of the polymer particles (a-2) to be practically sufficient.

A polymerization reaction suppressing agent can be used for polymerization of the polymer particles (a-2) as needed. The polymerization reaction suppressing agent is a compound added to an emulsion polymerization system to decrease a radical polymerization rate. More specifically, the polymerization reaction suppressing agent includes a polymerization rate retardant, a polymerization inhibitor, a chain transfer agent with low radical reinitiation reactivity, and a monomer with low radical reinitiation reactivity. The polymerization reaction suppressing agent is usually used for adjusting a polymerization reaction rate and adjusting physical properties of a latex. These polymerization reaction suppressing agents are added to a reaction system by batch operation or continuous operation. When the polymerization reaction suppressing agent is used, strength of a latex coating improves, and wear resistance of the plate thus improves. While details of the reaction mechanism is unclear, the polymerization reaction suppressing agent is thought to closely relate to steric structure of a polymer, and it is assumed that the polymerization reaction suppressing agent thus has an effect of adjusting physical properties of a latex coating.

Examples of the polymerization reaction suppressing agent include, but not particularly limited to, quinones such as o-, m-, or p-benzoquinone; nitro compounds such as nitrobenzene, o-, m-, or p-dinitrobenzene; amines such as diphenylamine; catechol derivatives such as tertiary butyl catechol; 1,1-di-substituted vinyl compounds such as 1,1-diphenylethylene or α-methylstyrene and 2,4-diphenyl-4-methyl-1-pentene; and 1,2-di-substituted vinyl compounds such as 2,4-diphenyl-4-methyl-2-pentene and cyclohexene. Besides, compounds described as a polymerization inhibitor or polymerization suppressing agent in "POLYMER HANDBOOK 3rd Ed. (J. Brandup, E.H. Immergut: John Wiley & Sons, 1989)," and "Kaitei koubunshigousei no kagaku (Chemistry of polymer synthesis revised edition) (Otsu: Kagaku-Dojin Publishing Company, INC, 1979)" are exemplified.

Among them, 2,4-diphenyl-4-methyl-1-pentene (α-methylstyrene dimer) is especially preferable in view of reactivity. These polymerization reaction suppressing agents may be used singly, or two or more thereof may be used in combination.

The amount of these polymerization reaction suppressing agents used is preferably 10% by mass or less based on the total amount of monomers used for polymerization of the polymer particles (a-2). By setting the amount to 10% by mass or less, a practically sufficient polymerization rate tends to be obtained.

Various polymerization adjusters such as a pH adjuster and a chelating agent can be added at the time of synthesizing the polymer particles (a-2) as needed.

The pH adjuster is not particularly limited, and examples thereof include sodium hydroxide, potassium hydroxide, ammonium hydroxide, sodium hydrogen carbonate, sodium carbonate, and disodium hydrogen phosphate.

The chelating agent is not particularly limited, and examples thereof include sodium ethylenediaminetetraacetate.

Furthermore, as other additives, various additives may be added, including a viscosity reducing agent such as an alkali-sensitive latex and hexametaphosphoric acid; a water-soluble polymer such as a polyvinyl alcohol and carboxymethyl cellulose; a thickening agent; various antioxidants; an ultraviolet absorber; an antiseptic agent; a bactericidal agent; a defoaming agent; a dispersant such as sodium polyacrylate; a water resistant agent; a metal oxide such as zinc oxide; a crosslinking agent such as an isocyanate-based compound and an epoxy compound; a lubricant; and a water retaining agent.

A method for adding these additives is not particularly limited, and these additives can be added during synthesis or after synthesis of the polymer particles (a-2).

The polymerization temperature in the case where the polymer particles (a-2) is synthesized through emulsion polymerization is usually 60 to 120°C. Polymerization may be carried out by the above-described redox polymerization method or the like at a lower temperature. Furthermore, a metal catalyst such as divalent iron ion, trivalent iron ion, and copper ion may be allowed to coexist as a redox catalyst.

### 1.2.3. Photopolymerizable monomer (a-3)

Examples of the photopolymerizable monomer (a-3) include, but not particularly limited to, esters of acids such as acrylic acid, methacrylic acid, fumaric acid, and maleic acid; derivatives of acrylamides and methacrylamides; allyl esters, styrene, and derivatives thereof; and N-substituted maleimide compounds.

Examples of the photopolymerizable monomer (a-3) include, but not particularly limited to, diacrylates and dimethacrylates of alkanediols such as 1,6-hexanediol and 1,9-nonanediol; or diacrylates and dimethacrylates of ethylene glycol, diethylene glycol, propylene glycol, dipropylene glycol, polyethylene glycol, butylene glycol, and dicyclopentadienyl; trimethylolpropane tri(meth)acrylate, dimethyloltricyclodecane di(meth)acrylate, isobornyl (meth)acrylate, phenoxypolyethyleneglycol (meth)acrylate, pentaerythorit tetra(meth)acrylate, N,N'-hexamethylenebisacrylamide and N,N'-hexamethylenebismethacrylamide, styrene, vinyltoluene, divinylbenzene, diacrylphthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenylpropyl) fumarate, dilauryl fumarate, dibehenyl fumarate, and N-lauryl maleimide. These may be used singly, or two or more thereof may be used in combination.

A di(meth)acrylate monomer having two (meth)acrylate groups in one molecule is preferable as the photopolymerizable monomer (a-3) in view of higher chipping resistance at a convex part of a printing plate. The content of such a di(meth)acrylate monomer is preferably 2.0% by mass or more, more preferably 2.0 to 20% by mass, and still more preferably 5.0 to 16% by mass based on the total amount of the photosensitive resin composition.

The content of the photopolymerizable monomer (a-3) is preferably 1 to 25% by mass, more preferably 5 to 20% by mass, and still more preferably 8 to 15% by mass based on 100% by mass of the total amount of the photosensitive resin composition in view of achieving bright printing.

### 1.2.4. Photopolymerization initiator (a-4)

The photopolymerization initiator (a-4) is a compound absorbing energy of light and generating a radical. Various known initiators can be used therefor, and various organic carbonyl compounds, especially aromatic carbonyl compounds are preferably used.

Examples of the photopolymerization initiator (a-4) include, but not particularly limited to, benzophenone, 4,4-bis(diethylamino)benzophenone, t-butyl anthraquinone, 2-ethyl anthraquinone, thioxanthones such as 2,4-diethylthioxanthone, isopropylthioxanthone, and 2,4-dichlorothioxanthone; acetophenones such as diethoxyacetophenone, 2,2-dimethoxy-phenylacetophenone, 2-hydroxy-2-methyl-1-phenylpropane-1-on, benzyl dimethyl ketal, 1-hydroxycyclohexyl-phenyl ketone, 2-methyl-2-morpholino(4-thiomethylphenyl)propane-1-on, and 2-benzyl-2-dimethylamino-1-(4-morpholinophenyl)-butanone; benzoin ethers such as benzoin methyl ether, benzoin ethyl ether, benzoin isopropyl ether, and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; methyl benzoylformate; and 1,7-bisacridinylheptane; 9-phenylacridine; and 2,6-di-t-butyl-p-cresol. These may be used singly, or two or more thereof may be used in combination.

The content of the photopolymerization initiator (a-4) is preferably 0.1 to 10.0% by mass, more preferably 1.0 to 8.0% by mass, and still more preferably 1.5 to 5.0% by mass based on 100% by mass of the total amount of the photosensitive resin composition in view of improving plate formability during plate making and achieving bright printing.

A cleavable photopolymerization initiator and a hydrogen-drawing type photopolymerization initiator may be used in combination as the photopolymerization initiator (a-4). The amount of the hydrogen-drawing type photopolymerization initiator in the photosensitive resin composition is preferably 1.0% by mass or less and more preferably 0.5% by mass because image reproducibility of a printing plate and abrasion resistance are high.

### 1.2.5. Liquid diene (a-5)

The photosensitive resin composition layer may contain liquid diene (a-5). The liquid diene is a liquid compound having a carbon-carbon double bond. The term "liquid" of the "liquid diene" used herein means a form having the property of being easily flow-deformable and capable of being solidified into a deformed shape by cooling, and corresponds to an elastomer having the following property: when external force is applied, deformation occurs instantly depending on the external force, and when the external force is removed, the original shape is recovered in a short time.

The liquid diene(a-5) is not particularly limited, and examples thereof include liquid polybutadiene, liquid polyisoprene, a modified product of liquid polybutadiene, a modified product of liquid polyisoprene, a liquid acrylonitrile-butadiene copolymer, and a liquid styrene-butadiene copolymer. The liquid diene is defined as a copolymer having 50% by mass or more of a diene component.

Among them, liquid polybutadiene is preferable as the liquid diene (a-5) in view of mechanical properties of the flexographic printing raw plate of the present embodiment and a flexographic printing raw plate using the same.

The number average molecular weight of the liquid diene (a-5) is not particularly limited as long as it is liquid at 20°C. The number average molecular weight is preferably 500 or more and 60000 or less, more preferably 500 or more and 50000 or less, and still more preferably 800 or more and 50000 or less in view of wear resistance and handleability of a flexographic printing plate obtained by using the flexographic printing raw plate of the present embodiment.

The content of the liquid diene (a-5) in the photosensitive resin composition layer is preferably 10 to 40% by mass, more preferably 15 to 40% by mass, and still more preferably 20 to 40% by mass based on 100% by mass of the total amount of the photosensitive resin composition layer in view of wear resistance of the flexographic printing raw plate of the present embodiment and a flexographic printing plate using the same.

### 1.2.6. Silicone compound (a-6)

Examples of the silicone compound (a-6) include silicone oil, a silane coupling agent, a silane compound, silicone rubber, and silicone resin. Among them, silicone oil is preferable because its component easily migrates to surface to highly exhibit the effect of decreasing surface energy.

The silicone compound (a-6) is not particularly limited, and examples thereof include a compound having a polyalkylsiloxane such as polydimethylsiloxane or polydiethylsiloxane in its main chain. The silicone compound (a-6) may be a compound having polysiloxane structure at a part of its molecular. The silicone compound (a-6) may be a compound in which a certain organic group is introduced into polysiloxane structure. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both of a side chain and a terminal of polysiloxane, and the like can be used.

The organic group to be introduced into polysiloxane structure is not particularly limited, and examples thereof include an amino group, a carboxy group, a carbinol group, an aryl group, an alkyl group, an alkoxycarbonyl group, an alkoxy group, a linear or branched alkyl group substituted with at least one aryl group, and a polyoxyalkylene group (hereinafter also referred to as a polyether group).

Among them, silicone oil having polysiloxane as a main skeleton and having one or more groups selected from the group consisting of an amino group, a polyether group, and a carbinol group at at least one end is more preferable as the silicone compound (a-6). When such a silicone compound (a-6) is used, transparency of the photosensitive resin composition layer tends to more improve. A commercially available product of such a silicone compound is not particularly limited, and examples thereof include KF-6000 manufactured by Shin-Etsu Chemical Co., Ltd.

The content of the silicone compound (a-6) is preferably 0.1 to 5.0% by mass, more preferably 0.5 to 3.0% by mass, and still more preferably 0.5 to 2.0% by mass based on the total amount of the photosensitive resin composition layer.

### 1.3. Ink absorbing layer

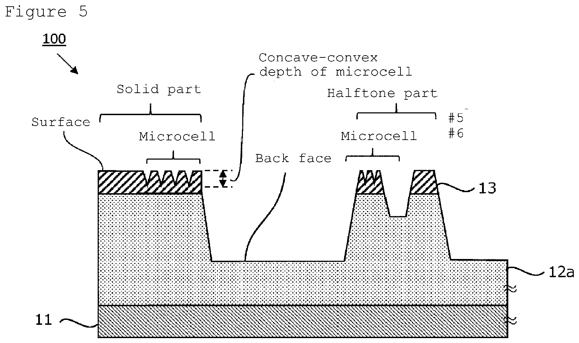

The flexographic printing raw plate of the present embodiment has an ink absorbing layer between the photosensitive resin composition layer and an infrared ablation layer described later. The ink absorbing layer needs to adhere to the photosensitive resin composition layer and remain in an obtained flexographic printing plate during the course of developing, when exposed to a developer such as water or a solvent, or when rubbed with a developing brush or a nonwoven fabric. Hence, a larger film thickness of the ink absorbing layer in the flexographic printing raw plate is preferable. A larger film thickness of the ink absorbing layer in the flexographic printing raw plate is also preferable for forming a microcell, as described later, because convex parts of dots are easy to process (see Figure 5).

On the other hand, a relief is formed such that the depth of a concave part between dots is about 100 µm. Hence, dots themselves are formed from a component of the ink absorbing layer with increase in the film thickness of the ink absorbing layer. This facilitates accumulating ink between dots (in a concave part).

Taking the balance among them into consideration, the film thickness of the ink absorbing layer is 5 µm or more and 50 µm or less, preferably 10 µm or more and 45 µm or less, and more preferably 10 µm or more and 40 µm or less.

The difference between surface free energy of the ink absorbing layer, Ei, and surface free energy of the photosensitive resin composition layer, Ep, (i.e., Ei - Ep) is preferably larger than 0 mJ/m² and 5 mJ/m² or less, more preferably larger than 0 mJ/m² and 4 mJ/m² or less, still more preferably 0.5 to 3.5 mJ/m², and further preferably 1.0 to 3.5 mJ/m². In this respect, when the difference between the surface free energy of the ink absorbing layer and the surface free energy of the photosensitive resin composition layer, Ei - Ep, is 5 mJ/m² or less, inking properties of a flexographic printing plate to be obtained more improve, and furthermore, adhesion between the ink absorbing layer and the photosensitive resin composition layer tends to be maintained even after developing. It is preferable that the surface free energy of the ink absorbing layer, Ei, be larger than the surface free energy of the photosensitive resin composition layer, Ep. For example, as disclosed in Patent Literature 4 mentioned above, when the surface free energy of the ink absorbing layer, Ei, is larger by 5 mJ/m² than the surface free energy of the photosensitive resin composition layer Ep, the resulting printing plate is not suitable for printing a highlight area with high definition and easily thickens a halftone on a printed matter. The reason for this is presumably as follows: when the surface free energy of the ink absorbing layer, Ei, is larger by 5 mJ/m² than the surface free energy of the photosensitive resin composition layer, Ep, ink is less likely to be accumulated in a concave part of a photosensitive resin, and accordingly, ink is excessively supplied to a convex part.

The surface free energy herein is evaluated as the resin characteristics of each of the ink absorbing layer and the photosensitive resin composition. The surface free energy of the ink absorbing layer refers to the surface free energy of the outermost surface of a resin plate to be exposed to developing (see Figure 5), and a "back face" part shown in Figure 5 was evaluated and used for the surface free energy of the photosensitive resin composition.

From the same viewpoint as above, the surface free energy of the ink absorbing layer, Ei, is preferably 33 to 43 mJ/m², preferably 34 to 42 mJ/m², and more preferably 35 to 41 mJ/m². The surface free energy of the photosensitive resin composition layer, Ep, is preferably 30 to 40 mJ/m², preferably 31 to 39 mJ/m², more preferably 32 to 38 mJ/m². The surface free energy can be determined by a method described in Examples.

### 1.3.1. Zeta potential

The zeta potential of the ink absorbing layer of the present embodiment is preferably a positive value. When the zeta potential of the ink absorbing layer is a positive value, water-based ink tends to have a higher density when printed and transferred to a film using a flexographic printing plate obtained from the flexographic printing raw plate.

Although a detailed reason why transferred water-based ink has a higher density when the zeta potential of the ink absorbing layer is positive is not clear, the present inventors surmise the following. While a method of printing with water-based ink using the flexographic printing plate of the present embodiment will be described later, a binder resin having a salt structure in which a carboxyl group and ammonium as a counter cation thereof are adopted, or a binder resin similar thereto is often used as water-based ink in order to improve "resolubility" described above in relation to the problem. In the case of using such water-based ink, when the ink absorbing layer according to the present embodiment is a positively charged film, i.e., when the zeta potential is positive, the ink absorbing layer easily interacts with the carboxyl group of the binder resin in the water-based ink and retains an increased amount of the water-based ink, presumably resulting in an increased ink density of a printed matter.

The zeta potential of the ink absorbing layer can be measured using a membrane zeta potential analyzer (Otsuka Electronics Co., Ltd., ELSZ). Specifically, after loading a measurement sample in a measurement cell, the rate of electroosmotic flow induced by parallel application of an electric field to the sample film using a 10 mM NaCl aqueous solution is observed as a kinetic rate of uncharged polystyrene latex (500 nm) modified with hydroxypropyl cellulose, and the zeta potential can be determined from the kinetic rate.

It is also preferable that the ink absorbing layer can be cleaned with the same cleaning liquid as that for the infrared ablation layer and/or the photosensitive resin composition layer in a manufacturing process of a flexographic printing plate described later. When the ink absorbing layer has such cleanability, the ink absorbing layer can be washed together with the photosensitive resin composition layer and the like. This is preferable in view of convenience in a manufacturing process of a flexographic printing plate because there is no need of adding a special step for cleaning the ink absorbing layer.

A manufacturing process of a flexographic printing plate is not particularly limited, and it is preferable that the flexographic printing raw plate of the present invention be produced by preparing a cover film sequentially wet-coated with an infrared ablation layer and an ink absorbing layer, and then allowing it to adhere or bond to a photosensitive resin composition layer. As described later, since the infrared ablation layer mainly includes a hydrophobic compound, a hydrophilic component is preferably used in the ink absorbing layer to be applied onto the infrared ablation layer. This permits coating with the infrared ablation layer and the ink absorbing layer without mixing them.

In this view, the ink absorbing layer preferably includes a hydrophilic component. The component included in such an ink absorbing layer is not particularly limited, and examples thereof include polymer particles (b-1), a thickening agent (b-2), a silicone compound (b-3), a binder resin (b-4), a layered inorganic compound (b-5), a water-soluble photopolymerization initiator (b-6), a water-soluble polymerizable compound (b-7), a water-soluble crosslinking agent (b-8), and a surfactant (b-9). Among them, the ink absorbing layer preferably includes polymer particles (b-1), a thickening agent (b-2), and a silicone compound (b-3). Hereinafter, each component contained in the ink absorbing layer will be described in detail.

### 1.3.2. Polymer particles (b-1)

The ink absorbing layer needs to adhere to the photosensitive resin composition layer and remain in an obtained flexographic printing plate during the course of developing, when exposed to a developer such as water or a solvent, or when rubbed with a developing brush or a nonwoven fabric.

In this view, the ink absorbing layer includes predetermined polymer particles (b-1). The polymer particles (b-1) are not particularly limited, and examples thereof include (b-1-1) polymer particles containing a butadiene skeleton and having a carboxyl group and/or a hydroxy group, and/or (b-1-2) polymer particles obtained by polymerizing a monobasic or polybasic acid monomer. Examples of the polymer particles (b-1-1) and the polymer particles (b-1-2) include those described for the polymer particles (a-2-1) and the polymer particles (a-2-2) included in the photosensitive resin composition layer. When such polymer particles (b-1) are used, adhesion between the ink absorbing layer and the photosensitive resin composition layer tends to more improve during the course of developing.

The polymer particles (b-1) are preferably another polymer having a butadiene skeleton, a polymer having an isoprene skeleton, and a polymer obtained by further polymerizing a (meth)acrylic acid ester and/or a monomer having a carboxyl group and/or a hydroxy group with the polymer having an isoprene skeleton. When such polymer particles (b-1) are used, adhesion between the ink absorbing layer and the photosensitive resin composition layer tends to more improve during the course of developing.

Particularly, when polymer particles containing a butadiene skeleton are used, adhesion between the ink absorbing layer and the photosensitive resin composition layer tends to more improve so that the ink absorbing layer is easily maintained even after developing. Surprisingly, the ink absorbing layer, when polymer particles containing a butadiene skeleton are used, can exert high lithography performance, and moldability of a microcell tends to more improve.

The polymer included in the polymer particles (b-1) having a butadiene skeleton or an isoprene skeleton is not particularly limited, and examples thereof include polymers having a butadiene skeleton, such as a polybutadiene, acrylonitrile-butadiene copolymer, a styrene-butadiene copolymer, and a (meth)acrylate-butadiene copolymer; and polymers having an isoprene skeleton, such as polyisoprene and polychloroprene.

The polymer included in the polymer particles (b-1) containing a butadiene skeleton and having a carboxyl group and/or a hydroxy group is not particularly limited, and examples thereof include a polymer obtained by further polymerizing a monomer having a carboxyl group and/or a hydroxy group with the polymer included in the polymer particles containing a butadiene skeleton. The monomer having a carboxyl group herein means the monobasic acid monomer and/or the polybasic acid monomer. The polymer particles (b-1) may be used singly or in combinations of two or more thereof.

The polymer particles (b-1) may have a polar group such as a carboxyl group and/or a hydroxy group as described above. Such a polar group is not particularly limited, and examples thereof include a carboxyl group and a hydroxy group as well as hydrophilic groups such as a phosphoric acid group and a sulfonic acid group, or salts thereof. Hydrophilicity of the ink absorbing layer having such a polar group tends to more improve. As described later, in a manufacturing process of the flexographic printing raw plate, the flexographic printing raw plate of the present invention is produced by preparing a cover film sequentially wet-coated with an infrared ablation layer and an ink absorbing layer, and then allowing it to adhere or bond to a photosensitive resin composition layer. In this respect, since the infrared ablation layer includes mainly a hydrophobic component, a hydrophilic component is preferably used in the ink absorbing layer to be applied thereonto. Such improved hydrophilicity of the ink absorbing layer tends to suppress admixture between the infrared ablation layer and the ink absorbing layer in a wet manufacturing process of the flexographic printing raw plate.

The ink absorbing layer including the polymer particles (b-1) as described above is cured in a manufacturing process of the flexographic printing raw plate described later even in the absence of the water-soluble photopolymerization initiator (b-6) or the water-soluble polymerizable compound (b-7). Although a detailed reason for this is not clear, the present inventors surmise the following mechanism: in a manufacturing process of a flexographic printing plate, heat generated in ablation of the infrared ablation layer described later by irradiation with IR laser diffuses to the ink absorbing layer located beneath the infrared ablation layer so that the polymer particles (b-1) are fused and thermally cured; and/or radicals generated in radical photopolymerization of the photosensitive resin composition layer by irradiation with visible light diffuse to the ink absorbing layer so that the butadiene skeleton or the like included in the polymer particles (b-1) is crosslinked by the radicals.

Surprisingly, the ink absorbing layer including the polymer particles (b-1) as described above is cured in a manufacturing process of the flexographic printing raw plate described later even in the absence of the water-soluble photopolymerization initiator (b-6) or the water-soluble polymerizable compound (b-7), and is also cured even when the ink absorbing layer contains a polymerization inhibitor. Therefore, the surmise described above may be true. However, the mechanism is not limited to those described above.

A commercially available product of the polymer particles (b-1) is not particularly limited, and examples thereof include SB Latex L7430, A2730, A7141, A6006, and L5390 manufactured by Asahi Kasei Corp., and LACSTAR DN703, 1570B, and 6541G manufactured by DIC Corp.

The content of the polymer particles (b-1) in the ink absorbing layer in the flexographic printing plate of the present embodiment is preferably 20% by mass or more, more preferably 35% by mass or more, still more preferably 50% by mass or more, further preferably 65% by mass or more, and still further preferably 80% by mass or more based on the total amount of the ink absorbing layer in view of ensuring adhesion to the photosensitive resin composition layer. The content of the polymer particles (b-1) is preferably 95% by mass or less based on the total amount of the ink absorbing layer. When the content of the polymer particles (b-1) in the ink absorbing layer is 20% by mass or more, adhesion between the ink absorbing layer and the photosensitive resin composition layer tends to more improve in a flexographic printing plate to be obtained.

### 1.3.3. Thickening agent (b-2)

The ink absorbing layer may include a thickening agent (b-2) in view of adjusting a film thickness at the time of coating with the ink absorbing layer.

The thickening agent (b-2) is not particularly limited and is preferably water-soluble. Examples of the aqueous thickening agent include SEPIGEL 305, NS, EG, FL, SEPIPLUS265, S, 400, SEPINOV EMT10, P88, and SEPIMAX ZEN (manufactured by Seiwa Kasei Co., Ltd.), ARON A-10H, A-20P-X, A-20L, A-30, A-7075, A-7100, A-7185, A-7195, A-7255, B-300K, B-500K, JULIMER(R) AC-10LHPK, AC-10SHP, RHEOGIC 260H, 845H, and JUNLON PW-120 (manufactured by Toagosei Co., Ltd.), DISPERBYK 410, 411, 415, 420, 425, 428, 430, 431, 7410ET, 7411ES, 7420ES, and OPTIFLO-L1400 (manufactured by BYK Japan KK), COSQUAT GA468 (manufactured by Osaka Organic Chemical Industry Ltd.), cellulose derivative-based materials (carboxymethylcellulose, methylcellulose, hydroxycellulose, etc.), protein-based materials (casein, sodium caseinate, ammonium caseinate, etc.), alginic acid-based materials (sodium alginate, etc.), polyvinyl-based materials (polyvinyl alcohol, polyvinylpyrrolidone, a polyvinyl benzyl ether copolymer, etc.), polyacrylic acid-based materials (sodium polyacrylate, a polyacrylic acid-(meth)acrylic acid copolymer, etc.), polyether-based materials (an ethylene oxide-propylene oxide copolymer (manufactured by Meisei Chemical Works, Ltd., ALKOX EP-10), Pluronic polyether (Pluronic: registered trademark), polyether dialkyl ester, polyether dialkyl ether, a urethane-modified product of polyether, an epoxy-modified product of polyether, etc.), and maleic anhydride copolymer-based materials (a partial ester of a vinyl ether-maleic anhydride copolymer, a half ester of semi-drying oil fatty acid allyl alcohol ester-maleic anhydride, etc.). Other examples of the thickening agent include polyamide wax salt, acetylene glycol, polysaccharides such as xanthan gum, diutan gum, and zenthan gum, and an oligomer or a polymer having a polar group at its molecular end or side chain. The thickening agents may be used singly or in combinations of two or more thereof.

Among them, the ink absorbing layer preferably includes a water-soluble resin having an alkylene oxide chain as the thickening agent. When such a thickening agent is included, water developability tends to more improve.

The content of the thickening agent (b-2) is preferably 1% by mass or more and 10% by mass or less, more preferably 1.5% by mass or more and 8% by mass or less, and still more preferably 2% by mass or more and 5% by mass or less based on 100% by mass of the total amount of the ink absorbing layer.

### 1.3.4. Silicone compound (b-3)

The ink absorbing layer can be formed by applying a material for forming the ink absorbing layer on an infrared ablation layer, for example. For the purpose of uniformly applying the ink absorbing layer onto the above-described infrared ablation layer, the ink absorbing layer preferably contains a silicone compound (b-3) or a surfactant (b-9) in view of controlling surface energy.

The silicone compound (b-3) is not particularly limited, and examples thereof include a compound having a polyalkylsiloxane such as polydimethylsiloxane or polydiethylsiloxane in its main chain. The silicone compound (b-3) may be a compound having polysiloxane structure at a part of its molecular. The silicone compound (b-3) may be a compound in which a certain organic group is introduced into polysiloxane structure. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both of a side chain and a terminal of polysiloxane, and the like can be used.

Among them, a silicone compound into which an organic group is introduced is preferably used in view of ensuring adhesiveness between the ink absorbing layer and the photosensitive resin composition layer.

The organic group to be introduced into polysiloxane structure is not particularly limited, and examples thereof include an amino group, a carboxy group, a carbinol group, an aryl group, an alkyl group, an alkoxycarbonyl group, an alkoxy group, a linear or branched alkyl group substituted with at least one aryl group, and a polyoxyalkylene group (hereinafter also referred to as a polyether group).

The silicone compound is not particularly limited, and examples thereof include modified silicone oil manufactured by Shin-Etsu Chemical Co., Ltd. (manufactured by Shin-Etsu Chemical Co., Ltd., KF-351A), and various kinds of organic group-substituted silicone oil manufactured by Wacker Asahikasei Silicone Co., Ltd., GE Toshiba Silicones Co., Ltd., and Dow Corning Toray Silicone Co., Ltd.

The content of the silicone compound (b-3) is preferably 1% by mass or more and 10% by mass or less, more preferably 1.5% by mass or more and 8% by mass or less, and still more preferably 2% by mass or more and 5% by mass or less based on 100% by mass of the total amount of the ink absorbing layer.

### 1.3.5. Binder resin (b-4)

The ink absorbing layer may include a binder resin (b-4). The binder resin (b-4) can be used without particular limitations as long as it is generally a water-soluble polymer having a water-soluble polar group, or emulsion particles that have the polar group and are present in a state dispersed in water. Specifically, examples thereof include a water-soluble poly(ethylenevinyl alcohol) copolymer, a polyvinyl alcohol, a partially saponified polyvinyl acetate, a partially saponified poly(ethylene oxide vinyl acetate) graft copolymer, a polyvinyl butyral, a polyvinyl pyrrolidone, a polyurethane, a polyester, a polyether, cellulose, a polyamide, a polyurethane, and a water-soluble phenol. These may be used singly, or two or more thereof may be used in combination.

Particularly, a water-soluble cationic resin or cationic resin particles are preferably used as the water-soluble binder resin (b-4). The cationic resin particles can be added as a cationic resin emulsion. The resin has a cationic group and can thus interact with a carboxyl group of a binder resin included in water-based ink described later, and accordingly, the resin has high affinity for the water-based ink.

(b-4) A binder resin having a basic group, such as a resin having a basic group in its constituent unit, a resin in which a basic group is introduced, or a resin treated so as to have basic surface can be used as the cationic resin. For example, a resin having one or more cationic sites such as an amine, an ammonium salt, a pyridinium salt, and an imidazolidinone salt can be used as the cationic resin. When such a binder resin is used, affinity for water-based ink tends to more improve.

Specifically, the cationic resin include polyvinylamine, polyallylamine, a copolymer or the like of acrylamide, polyamide, or a derivative thereof. A resin obtained by introducing a basic group in a resin skeleton such as urethane-based resin, acrylic resin, or vinyl acetate-based resin, or a resin obtained by treating such a resin so as to have basic surface can also be used as the cationic resin. Acrylic resin having a radical polymerizable monomer such as primary to tertiary amine (e.g., dimethylaminoethyl methacrylate) or quaternary ammonium as a constituent monomer can also be used as the cationic resin, for example. These may be used singly, or two or more thereof may be used in combination.

Among them, polyamide resin and/or polyurethane resin is preferably used as the binder resin (b-4) having a basic group. When such a binder resin (b-4) is used, the affinity of the ink absorbing layer for water-based ink can more improve and an ink density of a recorded matter to be obtained tends to more improve. A flexographic printing plate having such an ink absorbing layer is more suitable for water-based flexographic ink for film application.

The cationic resin is not particularly limited, and examples thereof include "Himacs SC-103 and SC-506" manufactured by HYMO Co., Ltd., "PP-17" manufactured by Meisei Chemical Works, Ltd., "Superflex 620 and 650" manufactured by DKS Co. Ltd., "HYDRAN CP7610 and CP7050" (polyurethane resin) and "DICFINE FZ-1000" (styrene-acrylic resin emulsion) manufactured by DIC Corp., "Harsize CP-300 and CP800" (styrene-acrylic resin emulsion) manufactured by Harima Chemicals Group, Inc., and "Polysol AP-1370" manufactured by Showa Denko K.K.

The polyamide resin is not particularly limited, and examples thereof include a substance obtained by polymerizing a hydrophilic monomer and caprolactam. A commercially available product of such polyamide resin is not particularly limited, and specific examples thereof include water-soluble nylon (manufactured by Toray Industries, Inc., trade name: AQ Nylon A series) which is a polycondensate of 2-aminoethylpiperazine adipate and ε-caprolactam, water-soluble nylon (manufactured by Toray Industries, Inc., trade name: AQ Nylon P series) which is a polycondensate of polyethylene glycol diammonium adipate and ε-caprolactam, and water-soluble nylon (manufactured by Toray Industries, Inc., trade name: AQ Nylon T series) which is a polycondensate of 2-aminoethylpiperazine adipate, polyethylene glycol diammonium adipate, and ε-caprolactam. These can be preferably used.

The content of such a cationic resin as the binder resin (b-4) is preferably 10% by mass or more and 50% by mass or less and more preferably 10% by mass or more and 40% by mass or less based on 100% by mass of the total amount of the ink absorbing layer. When the content of the cationic resin is 10% by mass or more, many basic groups are provided in the surface of the ink absorbing layer. Therefore, the ink absorbing layer easily interacts with water-based ink, and an ink density of a recorded matter to be obtained tends to more improve. When the content of the cationic resin is 10% by mass or less, ink tends to be less likely to adhere to a concave part.

For improving an ink density of a solid part of water-based ink, it is preferable that a microcell have a larger surface concave-convex depth. The ink absorbing layer preferably has oxygen inhibiting ability so as to provide such surface micro concavity and convexity. Examples of a resin having such oxygen inhibiting ability for the binder resin (b-4) includes the polyvinyl alcohol (PVA) described above. It is more preferable that the polyvinyl alcohol be used in combination with the layered inorganic compound (b-5) described later. When polyvinyl alcohol is used, an ink density of a recorded matter to be obtained tends to more improve. A flexographic printing plate having such an ink absorbing layer is more suitable for water-based flexographic ink for film application.

The polyvinyl alcohol (PVA) may be partially substituted with an ester, an ether, and an acetal as long as it contains a substantial amount of an unsubstituted vinyl alcohol unit having necessary water solubility. Likewise, a part thereof may contain another copolymer component. Specific examples of the polyvinyl alcohol include polyvinyl alcohol that is hydrolyzed at 71 to 100 mol% and has a degree of polymerization in the range of 300 to 2400.

A commercially available product of the polyvinyl alcohol is not particularly limited, and specific examples thereof include JMR-8M manufactured by JAPAN VAM & POVAL Co., Ltd., and PVA-105, PVA-110, PVA-117, PVA-117H, PVA-12, PVA-124, PVA124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 manufactured by Kuraray Co., Ltd.

The content of the binder resin (b-4) which is such PVA resin is preferably 10% by mass or more and 50% by mass or less and more preferably 10% by mass or more and 40% by mass or less based on 100% by mass of the total amount of the ink absorbing layer. When the content of the PVA resin is 10% by mass or more, a surface concave-convex depth of the ink absorbing layer is increased and an ink density of water-based ink tends to more improve. When the content of the PVA resin is 50% by mass or less, ink tends to be less likely to adhere to a concave part.

Although the contents of the cationic resin and the PVA are described above, the content of the whole binder resin (b-4) is preferably 10% by mass or more and 50% by mass or less and more preferably 10% by mass or more and 40% by mass or less based on 100% by mass of the total amount of the ink absorbing layer. When the content of the binder resin (b-4) is 10% by mass or more, an ink density of a recorded matter to be obtained tends to more improve. When the content of the binder resin (b-4) is 10% by mass or less, ink tends to be less likely to adhere to a concave part.

### 1.3.6. Layered inorganic compound (b-5)

In the present embodiment, the "layered inorganic compound" refers to an inorganic compound in which unit crystal layers are stacked to form layered particle. A compound which swells and/or is cleaved in water is preferable as the layered inorganic compound (b-5), and examples thereof include a clay compound having water swellability. Other examples include a compound containing aluminum hydroxide, barium sulfate, or potassium titanate dispersed in water. Among these compounds, a clay compound having water swellability and a compound containing aluminum hydroxide dispersed in water are especially preferable.

Among them, swellable mica is preferable. When swellable mica is used, an oxygen blocking property is effectively exerted and an ink density of a recorded matter to be obtained tends to more improve.

The size of the layered inorganic compound (b-5) is preferably a size such that the layered inorganic compound (b-5) is uniformly arranged in the ink absorbing layer to thereby exert labyrinth effect effectively and thus highly develops the oxygen blocking property of the ink absorbing layer. From such viewpoints, the layered inorganic compound (b-5) preferably has an average particle diameter of 10 µm or less and a thickness of 500 nm or less and more preferably has an average particle diameter of 10 µm or less and a thickness of 100 nm or less.

When the average particle diameter of the layered inorganic compound (b-5) is 1 µm or more, a sufficient oxygen blocking property tends to be exerted in the ink absorbing layer. When the average particle diameter is 10 µm or less, generation of appearance unevenness tends to be prevented. When the thickness of the layered inorganic compound (b-5) is 10 nm or more, the shape of particles can be maintained, which is preferable in practical use. When the thickness is 500 nm or less, uniform coating is possible, and a sufficient oxygen blocking property tends to be exerted.

A commercially available product of the layered inorganic compound (b-5) is not particularly limited, and examples thereof include Micromica (synthetic mica) and Somasif MEB-3 (registered trade mark of Katakura & Co-op Agri Corporation, swellable mica), KUNIPIA manufactured by KUNIMINE INDUSTRIES CO., LTD. (registered trade mark of KUNIMINE INDUSTRIES CO., LTD., montmorillonite), SUMECTON (registered trade mark of KUNIMINE INDUSTRIES CO., LTD.) SA (synthetic saponite); Bengel (registered trade mark of HOJUN Co., Ltd., purified product of natural bentonite) manufactured by HOJUN Co., Ltd., alumina sol F-1000, F-3000, 5N manufactured by Kawaken Fine Chemicals Co., Ltd., flake alumina powder Serath 00610, 02025, 02050, 05025, 05070, 07070, and 10030 manufactured by KINSEI MATEC CO., LTD., and TISMO D and TISMO N manufactured by Otsuka Chemical Co., Ltd.

The content of the layered inorganic compound (b-5) is preferably 10% by mass or less, more preferably 1 to 8% by mass, and still more preferably 3 to 7% by mass based on 100% by mass of the total amount of the ink absorbing layer. When the content of the layered inorganic compound (b-5) falls within the range described above, an ink density of a recorded matter to be obtained tends to more improve.

### 1.3.7. Water-soluble photopolymerization initiator (b-6)

The ink absorbing layer according to the present embodiment preferably includes a water-soluble photoinitiator (b-6) and a water-soluble polymerizable compound (b-7). When the ink absorbing layer includes these components, the ink absorbing layer can be photocured to improve wear resistance more, and adhesion between the ink absorbing layer and the photosensitive resin composition layer also tends to more improve.

The photopolymerization initiator (b-6) included in the ink absorbing layer is preferably water-soluble in view of coating as an aqueous film in a manufacturing method thereof as described above.

Examples of the photopolymerization initiator (b-6) include acetophenone-based photopolymerization initiators such as 2,2-diethoxyacetophenone, 2,4-diethoxyacetophenone, 1-(4-isopropylphenyl)-2-hydroxy-2-methylpropan-1-one, 1-hydroxy cyclohexyl phenyl ketone, 2-benzyl-2-dimethylamino-1-(4-morpholinophenyl)-butan-1-one, and 2-hydroxy-4'-(2-hydroxyethoxy)-2-methylpropiophenone (Omnirad 2959 (manufactured by IGM Resins B.V., trade name)); benzoin-based photopolymerization initiators such as benzoin, benzoin methyl ether, benzoin ethyl ether, benzoin isopropyl ether, and benzyl dimethyl ketal; benzophenone-based photopolymerization initiators such as benzophenone, benzoylbenzoic acid, methyl benzoylbenzoate, 4-phenylbenzophenone, hydroxybenzophenone, acrylated benzophenone, and 4-benzoyl-4'-methyldiphenyl sulfide; oxime ester-based photopolymerization initiators such as 1,2-octadione, 1-[4-(phenylthio)-2-(O-benzoyloxime)], ethanone, 1-[9-ethyl-6-(2-methylbenzoyl)-9H-carbazol-3-yl]-, 1-(O-acetyloxime), and PBG305 (manufactured by Changzhou Tronly New Electronic Materials Co., Ltd., trade name); and photopolymerization initiator mixtures such as 1-Irgacure 754 (manufactured by BASF SE, trade name). These photopolymerization initiators may be used singly or as a mixture of two or more thereof.

Among them, an acetophenone-based photopolymerization initiator or an oxime ester-based photopolymerization initiator is preferable in view of adhesion between the photosensitive resin composition layer and the ink absorbing layer after pattern formation.

The content of the water-soluble photopolymerization initiator (b-6) is preferably 1% by mass or more and 10% by mass or less, more preferably 1.5% by mass or more and 8% by mass or less, still more preferably 2% by mass or more and 6% by mass or less based on 100% by mass of the total amount of the ink absorbing layer. When the content of the water-soluble photopolymerization initiator (b-6) falls within the range described above, wear resistance more improves and adhesion between the ink absorbing layer and the photosensitive resin composition layer also tends to more improve.

### 1.3.8. Water-soluble polymerizable compound (b-7)

The water-soluble polymerizable compound (b-7) included in the ink absorbing layer according to the present embodiment is preferably water-soluble in view of coating as an aqueous film in a manufacturing method thereof as described above.

The water-soluble polymerizable compound (b-7) is not particularly limited, and 2-hydroxyethyl (meth)acrylate, 2-hydroxypropyl (meth)acrylate, glyceryl (meth)acrylate, (meth)acrylic acid, polyethylene glycol mono(meth)acrylate, tris(2-hydroxyethyl)isocyanurate triacrylate (Sartomer SR368, manufactured by Arkema S.A.), and dipentaerythritol pentaacrylate (SR399, manufactured by Arkema S.A.), for example, are used singly or as a mixture of two or more thereof.

The water-soluble polymerizable compound (b-7) more preferably has an amide skeleton or a urethane skeleton. When such a water-soluble polymerizable compound (b-7) is used, affinity for a binder resin included in water-based ink more improves and an ink density of a recorded matter to be obtained tends to more improve.

The water-soluble polymerizable compound (b-7) having an amide skeleton is not particularly limited, and examples thereof include N,N-dimethyl(meth)acrylamide, N-vinylacetamide, N-vinylformamide, N-vinyl-2-pyrrolidone, and acrylamide-based monomers (FOM-03010, 03006, 03007, 03008, and 03009 (manufactured by FUJIFILM Wako Pure Chemical Corp.)).

The water-soluble polymerizable compound (b-7) having a urethane skeleton is not particularly limited, and a commercially available product such as ART RESIN TX-1N, ART RESIN TX-17N, and ART RESIN TX-36N (manufactured by Negami Chemical Industrial Co., Ltd.), UA-W2A, UA-W2, UA-7000, UA-7100, and UA-7200 (manufactured by Shin-Nakamura Chemical Co., Ltd.), and aliphatic urethane (meth)acrylate (Sartomer CN981, CN1963, and CN989 (manufactured by Arkema S.A.)), for example, can be used.

The content of the water-soluble polymerizable compound (b-7) is preferably 5% by mass or more and 60% by mass or less, more preferably 10% by mass or more and 50% by mass or less, and still more preferably 20% by mass or more and 40% by mass or less based on 100% by mass of the total amount of the ink absorbing layer.

### 1.3.9. Water-soluble crosslinking agent (b-8)

The ink absorbing layer of the present embodiment may include a water-soluble crosslinking agent (b-8). When the water-soluble crosslinking agent (b-8) is used, a compound having an amino group, for example, included in the ink absorbing layer can be crosslinked. Crosslinking of the ink absorbing layer is thus accelerated, and physical resistance to a brush is increased in a development step in which the film thus remains easily.

It is preferable that the water-soluble crosslinking agent (b-8) be chemically stably present without causing crosslinking in a coating liquid consisting of an ink absorbing layer composition in a step of coating the infrared ablation layer described later with the coating liquid, and accelerate crosslinking under heat in a coating drying step.

In this view, the water-soluble crosslinking agent (b-8) is not particularly limited, and water-soluble methylol melamine or a water-dispersible and/or water-soluble block isocyanate compound, for example, is preferably used. Examples of the water-soluble methylol melamine include Nikaresin (manufactured by Nippon Carbide Industries Co., Inc.), and examples of the water-dispersible and/or water-soluble block isocyanate compound include Blocked Isocyanate SU-268A, MEIKANATE CX, DM-6400, and MEIKANATE TP-10 (manufactured by Meisei Chemical Works, Ltd.).

A block isocyanate monomer can also be used for the purpose of accelerating crosslinking between the compound having an amino group and the water-soluble polymerizable compound described above. Examples thereof include Karenz MOI-BM, MOI-BP, and MOI-DEM (manufactured by Showa Denko K.K.).

The content of the water-soluble crosslinking agent (b-8) is preferably 10% by mass or less, more preferably 1 to 8% by mass, and still more preferably 3 to 7% by mass based on the total amount of the ink absorbing layer. When the content of the water-soluble crosslinking agent (b-8) falls within the range described above, wear resistance tends to more improve.

### 1.3.10. Surfactant (b-9)

Examples of the surfactant include an anionic surfactant, an ionic surfactant, a nonionic surfactant, an anionic reactive surfactant, and a nonionic reactive surfactant.

Examples of the surfactant include, but not particularly limited to, anionic surfactants such as a sodium polyoxyethylene styrenated phenyl ether sulfate, a sodium polyoxyalkylene branched decyl ether sulfate, an ammonium polyoxyethylene isodecyl ether sulfate, a sodium polyoxyethylene tridecyl ether sulfate, a sodium polyoxyethylene alkyl (C8-C20) ether sulfate, an ammonium polyoxyethylene oleyl cetyl ether sulfate, a sodium polyoxyethylene oleyl cetyl ether sulfate, a polyoxyethylene tridecyl ether phosphate, a polyoxyethylene alkyl (C2-C16) ether phosphate, a polyoxyethylene alkyl (C2-C16) ether phosphate-monoethanolamine salt, a sodium alkyl (C2-C16) phosphate, an alkyl (C2-C16) phosphate-monoethanolamine salt, disodium lauryl sulfosuccinate, a disodium lauryl polyoxyethylene sulfosuccinate, a disodium polyoxyethylene alkyl (C2-C20) sulfosuccinate, a sodium linear alkylbenzene sulfonate, a linear alkylbenzene sulfonate, a sodium alpha-olefin sulfonate, phenolsulfonic acid, sodium dioctyl sulfosuccinate, sodium lauryl sulfate, and a higher fatty acid potassium salt;

ionic surfactants such as an alkyl (C8-C20) trimethylammonium chloride, an alkyl (C8-C20) dimethylethylammonium chloride, didecyldimethylammonium chloride, lauryl dimethyl benzyl ammonium chloride, stearyl dimethyl hydroxyethyl ammonium para-toluene sulfonate, stearyl dimethyl aminopropylamide, tributyl benzyl ammonium chloride, lauryl dimethyl aminoacetic acid betaine, laurylamide propyl betaine, cocamidepropyl betaine, octanamide propyl betaine, and lauryl dimethyl amine oxide; and nonionic surfactants such as a polyoxyalkylene tridecyl ether, a polyoxyethylene isodecyl ether, a polyoxyalkylene lauryl ether, a polyoxyalkylene alkyl ether, a mixture of a polyoxyalkylene ether and a polyether polyol, a polyether polyol, a polyoxyethylene sulfonated phenyl ether, a polyoxyethylene naphthyl ether, phenoxyethanol, a polyoxyethylene phenyl ether, a polyoxyethylene polyoxypropylene glycol, a polyoxyethylene lauryl ether, a polyoxyethylene oleyl cetyl ether, a polyoxyethylene oleate, a polyoxyethylene distearate, a polyoxyethylene glyceryl isostearate, polyoxyethylene-cured castor oil, coconut fatty acid diethanolamide, polyoxyethylene alkylamine, sorbitan trioleate, sorbitan sesquioleate, sorbitan monooleate, sorbitan monococoate, sorbitan monocaprylate, a polyoxyethylene sorbitan monococoate, a polyoxyethylene sorbitan monostearate, a polyoxyethylene sorbitan monooleate, octyl polyglycoside, a butyl polyglycoside, sucrose benzoate, sucrose acetate, and a sucrose fatty acid ester; anionic reactive surfactants such as an ammonium polyoxyethylene-1-(allyloxymethyl)alkyl ether sulfate and an ammonium polyoxyethylene nonyl propenyl phenyl ether sulfate; and nonionic reactive surfactants such as a polyoxyethylene nonyl propenyl phenyl ether.

The above-described surfactants may be used singly, or two or more thereof may be combined.

The surfactant may be added to another layer (for example, the photosensitive resin composition layer) in addition to the ink absorbing layer, and is preferably contained in an amount of 0.1% by mass or more and 5.0% by mass or less, more preferably contained in an amount of 0.5% by mass or more and 3.0% by mass or less, and still more preferably contained in an amount of 0.5% by mass or more and 2.0% by mass or less based on 100% by mass of the total amount of a layer to which the surfactant is added.

When 0.1% by mass or more of the surfactant is contained, cleaning speed at the time of development after exposure can be improved. When 5.0% by mass or less of the surfactant is contained, swelling of the flexographic printing raw plate tends to be suppressed.

### 1.4. Infrared ablation layer

The flexographic printing raw plate of the present embodiment has an infrared ablation layer above the photosensitive resin composition layer with the ink absorbing layer interposed therebetween. The infrared ablation layer can be subjected to lithography processing using infrared light and serves as a mask image when the photosensitive resin composition layer is exposed and cured. At the time when an unexposed part of the photosensitive resin composition layer is washed out after completion of the exposure, this infrared ablation layer is simultaneously removed.

The infrared ablation layer is preferably composed of a binder polymer and an infrared sensitive substance.

Examples of the binder polymer include a polyamide, a polyester, and a copolymer of a monovinyl-substituted aromatic hydrocarbon and a conjugated diene. Especially, a copolymer of a monovinyl-substituted aromatic hydrocarbon such as styrene, α-methyl styrene, and vinyltoluene and a conjugated diene such as 1,3-butadiene and isoprene are preferable. When the infrared ablation layer is formed by using such a binder polymer, affinity for the ink absorbing layer is high and adhesion is thus good.

When polyester is used as the binder polymer, a number average molecular weight thereof is preferably 300 or more and 10,000 or less. The polyester is not particularly limited, and preferable examples thereof include a polyester synthesized from an alkanediol and adipic acid, a polyester synthesized from an alkanediol and phthalic acid, a polycaprolactone, and a combination of two or more of these polyesters.

In addition, the polyester may include various functional groups such as an amino group, a nitro group, a sulfonic acid group, and a halogen as long as they do not impair compatibility with another binder polymer, the infrared sensitive substance, and a non-infrared radiation shielding substance.

The infrared sensitive substance is not particularly limited, and a simple substance or compound having strong absorption in a range of usually 750 to 2000 nm is preferably used, for example.

Such an infrared sensitive substance is not particularly limited, and examples thereof include inorganic pigments such as carbon black, graphite, copper chromite, and chromium oxide; and colorants such as a polyphthalocyanine compound, cyanine colorant, and metal thiolate colorant.

These infrared sensitive substances are added in an amount such that sensitiveness for ablation with a laser beam used is imparted. The content of the infrared sensitive substance is preferably 10 to 80% by mass based on the total amount of the infrared ablation layer.

In addition, a substance reflecting or absorbing radial rays such as ultraviolet light can be used as the infrared sensitive substance. A radiation absorber such as an ultraviolet absorber, carbon black, and graphite are preferable examples thereof, and the amount thereof added is set so as to achieve a required optical density. It is usually preferable that the infrared sensitive substance be added so as to achieve an optical density of two or more and preferably three or more.

### 2. Manufacturing method of flexographic printing plate

A method of making a flexographic printing plate from the flexographic printing raw plate may be, for example, a method including: a back exposure step of performing irradiation with ultraviolet light from the support side; an infrared irradiation step of irradiating the infrared ablation layer with infrared light for lithography processing of a pattern; a relief exposure step of performing relief exposure by irradiating the photosensitive resin composition layer with ultraviolet light via the ink absorbing layer using the infrared ablation layer in which the pattern is formed by lithography processing as a mask; and a development step of removing an unexposed part of the infrared ablation layer, the ink absorbing layer, and the photosensitive resin composition layer.

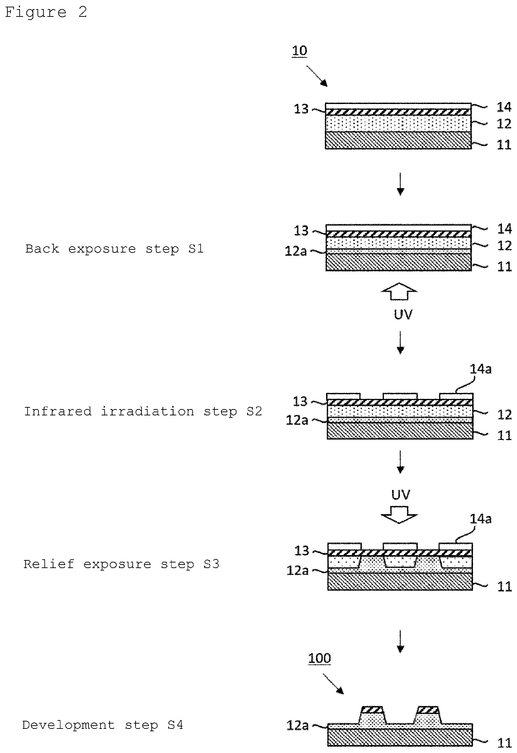

Figure 2 shows a schematic view showing a manufacturing method of a flexographic printing plate using the flexographic printing raw plate of the present embodiment. Hereinafter, each step will be described in detail.

### 2.1. Back exposure step

First, in back exposure step S1, the entire surface of photosensitive resin composition layer 12 is subjected to ultraviolet light exposure (back exposure) through support 11 of flexographic printing raw plate 10 and cured to form a thin uniform cured layer (back face 12a). This back face 12a serves as a part included in photocured photosensitive resin composition layer 12a to be formed in relief exposure step S3. In this respect, an exposure method is not particularly limited and can be conducted using a known irradiation unit.

A light source of ultraviolet light is not particularly limited, and a low pressure mercury lamp, a high pressure mercury lamp, an ultrahigh pressure mercury lamp, a metal halide lamp, a xenon lamp, a zirconium lamp, a carbon arc lamp, or a fluorescent lamp for ultraviolet light, for example, can be used.

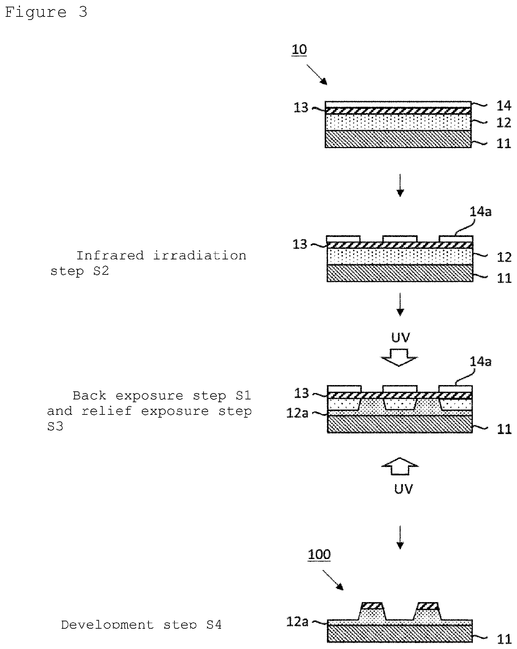

The back exposure step may be conducted before an infrared irradiation step, or as shown in Figure 3, the back exposure step S1 and relief step S3 may be simultaneously conducted. Figure 3 shows the same as that shown in Figure 2 except for the order of steps.

### 2.2. Infrared irradiation step

Next, in infrared irradiation step S2, negative pattern 14a is created in infrared ablation layer 14 on the photosensitive resin composition layer 12 by laser lithography (i.e. laser ablation). When the flexographic printing raw plate 10 has a cover film on the infrared ablation layer 14, the cover film is first peeled before infrared irradiation. Thereafter, the infrared ablation layer is subjected to pattern irradiation with infrared light, and a resin in the part irradiated with infrared light is decomposed for lithography processing of a pattern. A mask of the infrared ablation layer can thus be formed via the ink absorbing layer on the photosensitive resin composition layer.

By heat generated in this operation, the polymer particles (b-1) in the ink absorbing layer 13 located beneath the infrared ablation layer 14 may be fused and thermally cured, or the binder resin (b-4), the polymerizable compound (b-7), or the water-soluble crosslinking agent (b-8) may be cured.

### 2.3. Relief exposure step

In relief exposure step S3, image exposure (relief exposure) is conducted on the photosensitive resin composition layer 12 via the ink absorbing layer 13 using infrared ablation layer 14a in which the negative pattern is formed as a mask to form photocured photosensitive resin composition layer 12a.

In this respect, light that has passed through the mask accelerates curing reaction of the photosensitive resin composition layer, and concavity and convexity of the pattern formed in the infrared ablation layer is transferred in an inverted manner to the photosensitive resin composition layer. Irradiation with ultraviolet light may be conducted on the entire surface of the flexographic printing raw plate.

By radicals generated in this operation, an unsaturated bond contained in the polymer particles (b-1) in the ink absorbing layer 13 above the photosensitive resin composition layer 12 may be crosslinked, or the binder resin (b-4), the polymerizable compound (b-7), or the water-soluble crosslinking agent (b-8) may be cured.

### 2.4. Development step

Thereafter, in the development step, an unexposed part of the infrared ablation layer 14a, the ink absorbing layer 13, and the photosensitive resin composition layer 12 is removed. A removal method is not particularly limited, and the unexposed part may be washed away with a solvent-based developer or an aqueous developer, for example. Alternatively, an unexposed part heated to 40°C to 200°C may be brought into contact with an absorption layer capable of absorbing the unexposed part and the unexposed part is removed by removing the absorption layer.

Development can also be performed by heat. In the case of heat development, no solvent is used. Instead, the photosensitive resin composition layer and the ink absorbing layer are brought into contact with an absorbent material after image exposure and then heated. This adsorbent material is, for example, a porous nonwoven fabric made of nylon, polyester, cellulose, or an inorganic material. Heating is carried out up to a temperature at which an uncured part of the layer is capable of being liquified and absorbed to the nonwoven fabric. Subsequently, the nonwoven fabric that has thoroughly absorbed the uncured part is removed. Detailed heat development is disclosed in, for example, U.S. Patent No. 3,264,103, U.S. Patent No. 5,175,072, WO 96/14603, or WO01/88615. The mask can be removed in advance with an appropriate solvent or by heat in the same manner as above as needed.

Further, treatment exposure is then conducted as needed to obtain a flexographic printing plate. As a post treatment exposure, a method involving irradiating the surface with light having a wavelength of 300 nm or less is exemplified. Light having a wavelength of more than 300 nm may be used in combination as needed.

Either exposure from the infrared ablation layer side (relief exposure) or exposure from the support film side (back exposure) may be conducted first, or both may be simultaneously conducted. Examples of an exposure light source include a high pressure mercury lamp, an ultraviolet fluorescent lamp, a carbon arc lamp, and a xenon lamp.

An infrared laser can be used for laser lithography, and a laser with a wavelength of 750 to 2000 nm is preferable as the infrared laser. A semiconductor laser with a wavelength of 750 to 880 nm and Nd-YAG laser with a wavelength of 1060 nm are generally used as the infrared laser satisfying said wavelength range.

For developing the unexposed part of the photosensitive resin composition layer with a solvent-based developer, preferable examples of the solvent-based developer include esters such as heptylacetate and 3-methoxybutyl acetate; hydrocarbons such as a petroleum fraction, toluene, and decalin; a mixture of alcohols such as propanol, butanol, and pentanol with a chlorine-based organic solvent such as tetrachloroethylene; and ethers such as a polyoxyalkylene alkyl ether.

Washout of the unexposed part can be carried out by spraying from a nozzle and/or brushing with a brush.

When the unexposed part of the photosensitive resin composition layer is developed with an aqueous developer, the aqueous developer is a developer containing water as a main component. The aqueous developer may be water itself or may be a mixture of water with a surfactant such as a nonionic surfactant and an anionic surfactant, a pH adjuster, a cleaning accelerator, and the like, for example.

Examples of the nonionic surfactant include, but not particularly limited to, a polyoxyalkylenealkyl or alkenyl ether, a polyoxyalkylenealkyl or alkenyl phenyl ether, a polyoxyalkylenealkyl or alkenyl amine, a polyoxyalkylenealkyl or alkenyl amide, and an ethylene oxide/propylene oxide block-addition product.

Examples of the anionic surfactant include, but not particularly limited to, a linear alkylbenzene sulfonate having an alkyl having 8 to 16 carbon atoms on average, an α-olefin sulfonate having 10 to 20 carbon atoms on average, a dialkyl sulfosuccinate in which the alkyl group or alkenyl group thereof has 4 to 10 carbon atoms, a sulfonate of a fatty acid lower alkyl ester, an alkyl sulfate having 10 to 20 carbon atoms on average, an alkyl ether sulfate which has a linear or branched alkyl or alkenyl group having 10 to 20 carbon atoms on average and to which ethylene oxide is added in an average amount of 0.5 to 8 moles, and a saturated or unsaturated fatty acid salt having 10 to 22 carbon atoms on average.

Examples of the pH adjuster include, but not particularly limited to, sodium borate, sodium carbonate, sodium silicate, sodium metasilicate, sodium succinate, and sodium acetate. Among them, sodium silicate is preferable since sodium silicate is easily dissolved in water.

The cleaning accelerator described above enhances cleaning (developing) performance of a developer when the cleaning accelerator is used in combination with the surfactant and pH adjuster described above.

Examples of the cleaning accelerator include, but not particularly limited to, amines such as monoethanolamine, diethanolamine, and triethanolamine, ammonium salts such as tetramethylammonium hydroxide, and parafin-based hydrocarbons.

One or more selected from the group consisting of a surfactant such as a nonionic surfactant and an anionic surfactant, a pH adjuster, and a cleaning accelerator each can be added to and mixed with a developer in an amount within a range of preferably 0.1% to 50% by mass and more preferably 1% to 10% by mass.

In development, vibration may be additionally applied to the flexographic printing raw plate using ultrasonic waves or the like, or the surface of the printing raw plate may be additionally rubbed using mechanical means such as a brush.

It is preferable that a silicone compound be added to the solvent-based developer and aqueous developer in an amount of 0.01% by mass or more and 5% by mass or less in view of obtaining a flexographic printing plate excellent in ink adhesion and ink transfer properties. That is, the flexographic printing plate of the present embodiment is preferably a flexographic printing plate obtained through development with a developer containing a silicone compound in an amount of 0.01% by mass or more and 5% by mass or less at the time of development after forming a pattern on the flexographic printing raw plate and exposing the flexographic printing raw plate.

The silicone compound is not particularly limited, and examples thereof include silicone oil including a siloxane unit (hereinafter simply referred to as silicone oil), a silane coupling agent, a silane compound, silicone rubber, and silicone resin. Among these silicone compounds, silicone oil modified by an amino group, a polyether group, a carbinol group, or the like is preferable as the silicone compound to be contained in a developer.

### 3. Flexographic printing plate

The flexographic printing plate of the present embodiment is a flexographic printing plate including at least a support, a photocured photosensitive resin composition layer, and an ink absorbing layer sequentially stacked, in which the ink absorbing layer has a film thickness of 5 µm or more and 50 µm or less, and the ink absorbing layer includes polymer particles containing a butadiene skeleton and having a carboxyl group and/or a hydroxy group, and/or polymer particles obtained by polymerizing a monobasic or polybasic acid monomer.

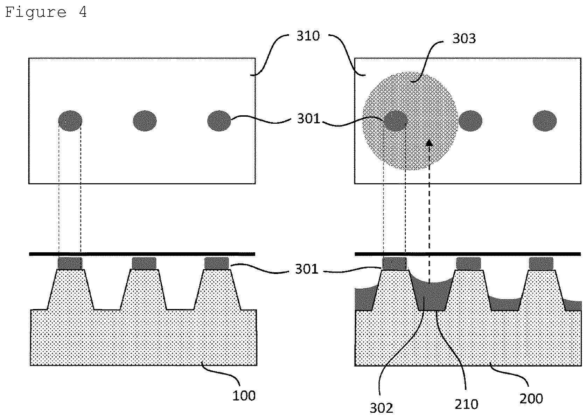

Figure 4 shows a schematic view for illustrating ink adhesion properties, and Figure 5 shows a schematic cross-sectional view of the flexographic printing plate of the present embodiment.

First, ink adhesion will be described. As shown in the left diagram of Figure 4, ideally, ink 301 attaches only to the top of a relief of flexographic printing plate 100, and the ink 301 is transferred to matter 310 to be printed. However, a problem of conventional flexographic printing plate 200 is that ink 302 is accumulated in relief concave part 210 and transferred to matter 310 to be printed along with transfer of ink 301. Particularly, when printing is continued for a long time, ink 302 often enters into the relief concave part 210 of the printing plate 200 (ink adhesion) and even part 303 intrinsically having no pictorial pattern yields a print.

By contrast, in the present embodiment, in which ink absorbing layer 13 is provided on the top of photocured photosensitive resin composition layer 12a, a concave part of the photocured photosensitive resin composition layer 12a has a physical property of being insusceptible to ink adhesion, while the top (ink absorbing layer 13) thereof can have a physical property of being excellent in printing characteristics.

As shown in Figure 5, the flexographic printing plate 100 has: support 11; photosensitive resin composition layer 12a after photocuring in which an arbitrary concave-convex pattern is formed by relief exposure; and ink absorbing layer 13 placed on the top of the photocured photosensitive resin composition layer 12a. Since the ink absorbing layer 13 is formed on the top of the photocured photosensitive resin composition layer 12a, ink attaches to the ink absorbing layer 13 at the time of printing and the ink that has attached to the ink absorbing layer 13 attaches to a matter to be printed to carry out flexographic printing.

### 3.1. Support

The support is not particularly limited, and the same as that illustrated in the flexographic printing raw plate, for example, can be used.

### 3.2. Photocured photosensitive resin composition layer

The photocured photosensitive resin composition layer 12a is a photosensitive resin composition layer in which a concave-convex pattern is formed.

### 3.3. Ink absorbing layer

The ink absorbing layer 13 is not particularly limited, and the same as that illustrated in the flexographic printing raw plate, for example, can be used.

The ink absorbing layer 13 is formed on the top of the photocured photosensitive resin composition layer 12a. In the ink absorbing layer 13, a solid part without concavity and convexity, a microcell, and a halftone part may be formed, as shown in Figure 5, according to an image to be printed. For creating a printed matter with high color saturation, it is preferable that the ink absorbing layer 13 carry a lot of ink. It is especially preferable that concavity and convexity such as a microcell be provided. The microcell herein refers to a part in which a fine pattern that does not influence design is made on the surface to form concavity and convexity which enhance ink transfer properties.

A larger concave-convex depth of the microcell allows the microcell to carry more ink, whereas too large a concave-convex depth limits an area of the concave part to be formed in a highlight part because the concave part has a larger diameter. Taking the balance among them into consideration, the concave-convex depth of the microcell to be formed in the flexographic printing plate is preferably 1 µm or more and 12 µm or less, more preferably 3 µm or more and 10 µm or less, and still more preferably 5 µm or more and 10 µm or less (see Figure 5).

Other configurations of the flexographic printing plate 100 can be the same as those already described in the flexographic printing raw plate 10. Hereinafter, other configurations of the flexographic printing plate 100 will be illustrated, and reference to the description of the flexographic printing raw plate 10 can be made for unillustrated parts.

A larger film thickness of the ink absorbing layer in the flexographic printing raw plate is also preferable for forming a microcell because convex parts of dots are easy to process (see Figure 5). On the other hand, a relief is formed such that the depth of a concave part between dots is about 100 µm. Hence, dots themselves are formed from a component of the ink absorbing layer with increase in the film thickness of the ink absorbing layer. This facilitates accumulating ink between dots (in a concave part). Taking the balance among them into consideration, the film thickness of the ink absorbing layer is 5 µm or more and 50 µm or less, preferably 10 µm or more and 45 µm or less, and more preferably 10 µm or more and 40 µm or less.

For example, a difference between surface free energy of the ink absorbing layer, Ei, and surface free energy of the photosensitive resin composition layer, Ep, (i.e., Ei - Ep) is preferably larger than 0 mJ/m² and 5 mJ/m² or less, more preferably larger than 0 mJ/m² and 4 mJ/m² or less, still more preferably 0.5 to 3.5 mJ/m², and further preferably 1.0 to 3.5 mJ/m². In this respect, when the difference between the surface free energy of the ink absorbing layer and the surface free energy of the photosensitive resin composition layer, Ei - Ep, is 5 mJ/m² or less, inking properties of a flexographic printing plate to be obtained more improve, and furthermore, adhesion between the ink absorbing layer and the photosensitive resin composition layer tends to be maintained even after developing.

It is preferable that the surface free energy of the ink absorbing layer, Ei, be larger than the surface free energy of the photosensitive resin composition layer, Ep, and it is preferable that the membrane zeta potential of the ink absorbing layer be a positive value. For example, when the surface free energy of the ink absorbing layer, Ei, is larger by 5 mJ/m² than the surface free energy of the photosensitive resin composition layer, Ep, the resulting printing plate is not suitable for printing a highlight area with high definition and easily thickens a halftone on a printed matter. The reason for this is presumably as follows: when the surface free energy of the ink absorbing layer, Ei, is larger by 5 mJ/m² than the surface free energy of the photosensitive resin composition layer, Ep, ink is less likely to be accumulated in a concave part of a photosensitive resin, and accordingly, ink is excessively supplied to a convex part.

The surface free energy herein is evaluated as the resin characteristics of each of the ink absorbing layer and the photosensitive resin composition. The surface free energy of the ink absorbing layer refers to the surface free energy of the outermost surface of a resin plate to be exposed to developing (see Figure 5), and a "back face" part shown in Figure 5 was evaluated and used for the surface free energy of the photosensitive resin composition.

From the same viewpoint as above, the surface free energy of the ink absorbing layer, Ei, is preferably 33 to 43 mJ/m², preferably 34 to 42 mJ/m², and more preferably 35 to 41 mJ/m². The surface free energy of the photosensitive resin composition layer, Ep, is preferably 30 to 40 mJ/m², preferably 31 to 39 mJ/m², more preferably 32 to 38 mJ/m². The surface free energy can be determined by a method described in Examples.

A constituent of the ink absorbing layer 13 is not particularly limited, and examples thereof include components described for the polymer particles (b-1), the thickening agent (b-2), the silicone compound (b-3), the binder resin (b-4), the layered inorganic compound (b-5), the water-soluble photopolymerization initiator (b-6), the water-soluble polymerizable compound (b-7), the water-soluble crosslinking agent (b-8), and the surfactant (b-9) illustrated in the flexographic printing raw plate.

The ink absorbing layer 13 has the same polymer particles as the polymer particles (b-1). Among them, the polymer particles are preferably polymer particles containing a butadiene structure and having a carboxylic acid group and/or a hydroxy group, and polymer particles obtained by polymerizing a monobasic or polybasic acid monomer, and more preferably polymer particles containing a butadiene structure and having a carboxylic acid group and/or a hydroxy group. The content of the polymer particles is preferably 20% by mass or more and 95% by mass or less based on 100% by mass of the ink absorbing layer.

The ink absorbing layer 13 preferably further includes polyvinyl alcohol resin or a binder resin having a basic group as the binder resin (b-4). Polyamide resin and/or polyurethane resin is more preferably included as the binder resin having a basic group.

The ink absorbing layer 13 preferably includes polyvinyl alcohol resin, swellable mica, a water-soluble photoinitiator, and a water-soluble polymerizable compound. Polyamide resin and/or polyurethane resin is preferably included as the binder resin having a basic group. The water-soluble polymerizable compound is preferably a compound having an amide skeleton and/or a urethane skeleton.

### 4. Recording method

The flexographic printing plate of the present embodiment can be mounted to a plate cylinder and used. A printing method is not particularly limited as long as it is a conventionally known one. For example, a roller brought into contact with ink is brought into contact with the flexographic printing plate mounted to a plate cylinder so that the ink is retained in the ink absorbing layer. Thereafter, the ink retained in the ink absorbing layer is transferred to the surface of a matter to be printed.

In response to growing interest in environmental responsiveness, a technique regarding aqueous ink for film printing application is disclosed in view of reduction in VOC (volatile organic compound) emission (e.g., Japanese Patent No. 6380775). Water-based ink compared with solvent ink has problems associated with adhesion to a film, blocking resistance accompanied by offset of a printing pictorial pattern, and "ink resolubility" so as to reduce adhesion stains resulting from the drying of ink on the plate during long-run printing, and intensive studies have been made on improvement.

The water-based ink for use in flexographic printing refers to water-based ink containing water as a main component of a solvent. The main component of a solvent refers to a component account for 50 wt% or more and preferably 80 wt% or more of the solvent. The solvent preferably has an alcohol content of 5 wt% or less.

The flexographic ink is constituted by a colorant such as a pigment, a vehicle such as a water-soluble resin or a resin, an aid such as a wax or a defoaming agent, and a solvent, for example, and a commercially available product may be used in the present embodiment.

In addition, the flexographic printing plate of the present embodiment can also be used for solvent ink.

### Examples

Hereinafter, the present invention will be described in detail with reference to specific working examples and comparative examples. However, the present invention is not limited to the following examples at all.

### [Manufacturing Example 1]

### (Synthesis of hydrophilic copolymer)

To a pressure resistant reaction vessel provided with a stirring device and a jacket for temperature adjustment were initially added 125 parts by mass of water and, as a reactive emulsifier, 2 parts by mass of "ADEKA REASOAP" (manufactured by ADEKA Corporation), an ammonium salt of (α-sulfo(1-nonylphenoxy)methyl-2-(2-propenyloxy)ethoxy-poly(oxy-1,2-ethanediyl). The inside temperature was increased to 80°C; and an oil-based mixture liquid including 2 parts by mass of t-dodecyl mercaptan and a monomer mixture including 10 parts by mass of styrene, 60 parts by mass of butadiene, 23 parts by mass of butyl acrylate, 5 parts by mass of methacrylic acid, and 2 parts by mass of acrylic acid and an aqueous solution including 28 parts by mass of water, 1.2 parts by mass of sodium peroxodisulfate, and 0.2 parts by mass of sodium hydroxide, and 2 parts by mass of an ammonium salt of (α-sulfo(1-nonylphenoxy)methyl-2-(2-propenyloxy)ethoxy-poly(oxy-1,2-ethanediyl) were added to the reaction vessel over five hours and six hours, respectively, at a constant flow rate.

Thereafter, the temperature was continuously kept at 80°C for one hour to complete polymerization reaction and obtain a copolymer latex, followed by cooling. Furthermore, pH of the produced copolymer latex was adjusted to 7 by sodium hydroxide, unreacted monomers were then removed by a steam stripping method followed by filtration with a 200 mesh metallic mesh, and the solid concentration of the filtrate was finally adjusted to 40% by mass to obtain an aqueous dispersion of a hydrophilic copolymer. The obtained aqueous dispersion of the hydrophilic copolymer was dried up by a vacuum dryer at 50°C to consequently remove water therefrom to thereby obtain the hydrophilic copolymer.

### [Manufacturing Example 2]

### (Production of base film (support) having adhesive layer)

As a solution for an adhesive layer to coat a base film (support), 55 parts by mass of Tufprene 912 (manufactured by Asahi Kasei Corp., trade name), which is a block copolymer of styrene and 1,3-butadiene, 38 parts by mass of paraffin oil (average carbon number: 33, average molecular weight: 470, and density at 15°C: 0.868), 2.5 parts by mass of 1,9-nonanediol diacrylate, 1.5 parts by mass of 2,2-dimethoxy-phenylacetophenone, 3 parts by mass of EPOXY ESTER 3000M (manufactured by Kyoeisha Chemical Co., Ltd., trade name), and 1.5 parts by mass of VALIFAST YELLOW-3150 (manufactured by ORIENT CHEMICAL INDUSTRIES CO., LTD., trade name) were dissolved in toluene to obtain a solution with a solid content of 25%.

Thereafter, the obtained solution was applied to one side of a polyester film having a thickness of 100 µm using a knife coater so as to achieve an ultraviolet transmittance of 10% followed by drying at 80°C for one minute to obtain a base film (support) having an adhesive layer. The UV transmittance of the support was calculated from transmission intensity measured by UV illuminometer MO-2 model (manufactured by ORC MANUFACTURING CO., LTD., trade name, UV-35 filter) using ultraviolet light exposure apparatus AFP-1500 (manufactured by Asahi Kasei Corp., trade name).

### [Manufacturing Example 3]

### (Production of film having infrared ablation layer)

After 65% by mass of Asaflex 810 (manufactured by Asahi Kasei Corp., trade name), which is a block copolymer of styrene and 1,3-butadiene, and 35% by mass of carbon black as an infrared sensitive substance were kneaded with a kneader and cut into a pellet, 90 parts by mass of this pellet and 10 parts by mass of 1,6-hexanediol adipate were dissolved, utilizing ultrasonic waves, in a solvent mixture prepared at a mass ratio of ethyl acetate/butyl acetate/propyleneglycol monomethyl ether acetate = 50/30/20 to prepare a uniform solution with a solid content of 12% by mass.

Thereafter, this solution was applied onto a polyester film to be a cover sheet with a thickness of 100 µm to achieve an applied amount after drying of 4 to 5 g/m² using a knife coater followed by drying at 80°C for one minute to obtain a film having an ultraviolet shielding layer (infrared ablation layer) capable of ablating by infrared light. The optical density of the film having the infrared ablation layer measured by DM-500 (manufactured by Dainippon Screen Mfg. Co., Ltd., trade name) was 3 to 4.

### [Manufacturing Example 4]

### (Production of cover film (film having ink absorbing layer and infrared ablation layer))

To a solution prepared at a mass ratio of ethanol/distilled water = 10/90 were added 92% by mass of water-dispersion latex (manufactured by Asahi Kasei Corp., L7430), 3% by mass of a thickening agent (ethylene oxide-propylene oxide copolymer, manufactured by Meisei Chemical Works, Ltd., ALKOX EP-10), and 5% by mass of modified silicone oil (manufactured by Shin-Etsu Chemical Co., Ltd., KF-351A) followed by stirring to prepare an ink absorbing layer coating liquid.

Thereafter, the ink absorbing layer coating liquid was applied onto the film having the infrared ablation layer produced in Manufacturing Example 3 described above, on the infrared ablation layer side thereof, so that the thickness after drying became 30 µm using a bar coater. A cover film having an ink absorbing layer and the infrared ablation layer was obtained by subsequent drying at 120°C for four minutes.

### [Example 1]

### (Production of flexographic printing raw plate)

After mixing 32 parts by mass of the hydrophilic copolymer obtained in Manufacturing Example 1 described above and 28 parts by mass of a styrene-butadiene-styrene copolymer [D-KX405: manufactured by Kraton Corporation] at 140°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of carbinol-modified silicone oil [KF-6000: manufactured by Shin-Etsu Chemical Co., Ltd.] was added little by little over 15 minutes, and additional kneading was carried out for 20 minutes after completion of addition to obtain a photosensitive resin composition.

Thereafter, the photosensitive resin composition was put into an extrusion molding machine, and extruded and molded from a T-shaped die, and on a face of the resulting photosensitive resin composition, the base film (support) having the adhesive layer obtained in Manufacturing Example 2 described above was laminated so that the adhesive layer contacted the photosensitive resin composition layer. A mold release film (manufactured by Mitsubishi Chemical Corporation, DIAFOIL MRV100) was further laminated on the face of the photosensitive resin composition layer opposed from the side on which the support was laminated, to obtain a stack of the support and the photosensitive resin composition layer.

Thereafter, the mold release film was peeled, and the ink absorbing layer obtained in Manufacturing Example 4 described above and the cover film having the infrared ablation layer were laminated so that the ink absorbing layer contacted the photosensitive resin composition layer to obtain a flexographic printing raw plate. Hereinafter, the photosensitive resin composition layer thus formed is referred to as form A (water).

### [Examples 2 to 13 and 16 to 39 and Comparative Examples 1 to 3 and 6 to 9]

Each flexographic printing raw plate was obtained in the same manner as in Example 1 described above except that the components used, the film thickness of the ink absorbing layer, and others were changed as shown in Tables 1 and 2 below.

### [Examples 14 and 15 and Comparative Examples 4 and 5]

In the production of a photosensitive resin composition, after mixing 60 parts by mass of a styrene-butadiene-styrene copolymer [D-KX405: manufactured by Kraton Corporation] at 180°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of amino-modified silicone oil [KF-8000: manufactured by Shin-Etsu Chemical Co., Ltd.] was added little by little over 15 minutes, and additional kneading was carried out for 20 minutes after completion of addition to obtain a photosensitive resin composition.

A flexographic printing raw plat was obtained under the same conditions as in [Example 1] except for the above. Hereinafter, a photosensitive resin composition layer formed by using the photosensitive resin composition described above is referred to as form B (solvent).

### [Comparative Example 10]

A photosensitive resin composition was obtained in the same manner as in Example 14 except that in the production of a photosensitive resin composition, 2 parts by mass of a fluoro ethylene vinyl ether copolymer (manufactured by AGC Inc., trade name: LUMIFLON LF916) were further added.

A flexographic printing raw plate was obtained under the same conditions as in [Example 1] except for the above. Hereinafter, a photosensitive resin composition layer formed by using the photosensitive resin composition described above is referred to as form B' (solvent).

### (Manufacturing of flexographic printing plate)

The flexographic printing raw plate described above was exposed from the side of the support (PET coated with an adhesive) using an ultraviolet light exposure apparatus (JE-A2-SS manufactured by Nihon Denshi Seiki Co., Ltd.) so that a pattern height (RD) after curing was about 0.6 mm.

Thereafter, the cover sheet of the infrared ablation layer was peeled, a halftone image (AM 175 lpi) was drawn on the infrared ablation layer using a laser ablation device (CDI) manufactured by ESKO, and the infrared ablation layer side was exposed at 8000 mJ under an air atmosphere using the above-described exposure apparatus. A site where a microcell (WSI pattern, manufactured by Esko-Graphics BV.) was provided was provided for solid part images.

Thereafter, each developing method described in Tables 2 and 4 was conducted by the following methods.

### (Water development)

After relief exposure, an aqueous solution (aqueous developer) of 1% polyoxyalkylene alkyl ether (NEWCOL 2308: manufactured by Nippon Nyukazai Co., Ltd.) and 1% potassium carbonate was prepared, and an unexposed part was removed by washing (development) at 40°C using a cleaning machine manufactured by Nihon Denshi Seiki Co., Ltd. (JOW-A3-P). After drying at 50°C for 10 minutes, the entire surface of the dried photosensitive resin plate was exposed at 1500 mJ/cm² with a sterilization lamp having 254 nm as a central wavelength (manufactured by Toshiba Corp., GL-30, trade name) using AFP-1216LF (manufactured by Asahi Kasei Corp., trade name), to remove surface tackiness. The post exposure dose from the sterilization lamp here was calculated from an illuminance measured using a UV-25 filter of the machine "UV-MO2".

### (Solvent development)

After relief exposure, development was conducted at a liquid temperature of 30°C at a rate of 100 mm/min in "AFP-1321P" developing machine (manufactured by Asahi Kasei Corp., trade name) with 3-methoxybutyl acetate as a developer, followed by drying at 60°C for 2 hours. Thereafter, in a post exposure treatment, the entire surface of the dried photosensitive resin plate was exposed at 2000 mJ/cm² using AFP-1216LF (manufactured by Asahi Kasei Corp., trade name) and a sterilization lamp having 254 nm as a central wavelength (manufactured by Toshiba Corp., GL-30, trade name) in order to remove surface tackiness. The post exposure dose from the sterilization lamp here was calculated from an illuminance measured using a UV-25 filter of the machine "UV-MO2".

### (Heat development)

After relief exposure, the printing plate was thermally processed in an experimental apparatus. A piece of 30 cm × 30 cm in size of the exposed printing plate was fixed to a motor-driven metal roll of 35 cm in diameter using a double-faced adhesive tape. A commercially available polyester nonwoven fabric was travelled on a heatable metal roll of 5 cm in diameter. An infrared lamp for relatively rapidly heating the printing plate was fixed to the roll on which the printing plate was held. The infrared lamp was turned on, and the heatable metal roll in a state heated to 170°C was slowly rotated (about 2 rpm) by a motor. The nonwoven fabric on the heatable metal roll was travelled and delivered at a contact pressure of about 2.5 × 10⁵ Pa. The roll on which the printing plate was held was subjected to 14 cycles to remove an uncured part.

### [Characteristic evaluation]

### (Evaluation of flexographic printing raw plate)

### <Surface free energy>

The surface free energy was calculated from contact angle measurement as to each of the flexographic printing raw plates obtained in Examples and Comparative Examples. Specifically, the contact angle of a part to be measured was measured by the liquid droplet method of a solid-liquid interface analysis apparatus DropMaster 501 (manufactured by Kyowa Interface Science Co., Ltd., trade name). After conditioning for 1 day in a constant temperature and humidity room having a temperature of 23°C and a relative humidity of 50%, the surface free energy of plate surface was automatically calculated from the built-in Kitazaki-Hata equation of FAMAS used as analysis software using purified water, ethylene glycol, and diiodomethane (manufactured by Kanto Chemical Co., Inc.) as probe solutions. A 22 G stainless needle (manufactured by Kyowa Interface Science Co., Ltd.) was used, and the contact angle was automatically measured at a discharge voltage of 4000 mV for a discharge time of 100 ms 15 seconds after contact of each probe solution with the plate. The resulting value was used.

### <Zeta potential>

The surface zeta potential was measured using a membrane zeta potential measurement apparatus (Otsuka Electronics Co., Ltd., ELSZ) as to each of the flexographic printing raw plates obtained in Examples and Comparative Examples. Specifically, after loading a measurement sample in a measurement cell, the rate of electroosmotic flow induced by parallel application of an electric field to the sample film using a 10 mM NaCl aqueous solution was observed as a kinetic rate of uncharged polystyrene latex (500 nm) modified with hydroxypropyl cellulose, and the zeta potential was determined from the kinetic rate.

### <Two-layer formation evaluation>

Dots formed in a 10% halftone area of AM 150 lines were morphologically observed under SEM (scanning electron microscope) as to each of the flexographic printing raw plates obtained in Examples and Comparative Examples. When an interfacial boundary between the ink absorbing layer and the photosensitive resin composition layer was found in the sample, it was determined that two layers were successfully formed.

Specifically, conductive treatment was carried out by coating with Au-Pd at a film thickness set to 30 nm using a thin film coating apparatus (vacuum device, MSP-1S). Thereafter, secondary electron image observation was conducted at an acceleration voltage of 5 kV using a scanning electron microscope (Keyence Corp., VHX-D510). In this operation, randomly selected halftone sites were observed at a magnification of 900×. When the observed images were captured into a computer, a contrast was appropriately adjusted using an auto contrast function before capture. Since a contrast is generated between the ink absorbing layer and the photosensitive resin composition layer, the interfacial boundary between the layers becomes visible. When such an interfacial boundary was found in a sample, it was determined that two layers were successfully formed.

### (Film thickness of ink absorbing layer)

The flexographic printing raw plate was exposed from the support side for 600 seconds using an ultraviolet light exposure apparatus. After photocuring the plate, the sample was processed by a focused ion beam (FIB) apparatus, and the exposed cross-section was observed using a scanning electron microscope (SEM) to evaluate the film thickness of the ink absorbing layer.

### <Evaluation of concavity and convexity of ink absorbing layer>

Dots were formed by introducing a microcell (Crystal Screen, Esko-Graphics BV.) in the laser lithography of the infrared ablation layer as to each of the flexographic printing plates obtained in Examples and Comparative Examples. The depth of the surface concave-convex of the microcell formed in the dot surface was measured using a laser microscope (Keyence Corp., VK-X100) .

### [Printing evaluation]

### (Evaluation of flexographic printing plate using solvent ink)

Actual printing evaluation was conducted using the flexographic printing plates obtained in Examples and Comparative Examples.

Flexographic printer AI-3 model (manufactured by Iyokikai Seisakusho) was used, and an OPP film was used as an object to be printed. Process X cyan (manufactured by TOYO INK CO., LTD., trade name) was used as solvent ink. A solvent was added, and the viscosity was adjusted for 15 seconds in Zahn cup #4 manufactured by Rigo Co., Ltd. before use. An anilox roll with 800 lpi (cell volume: 3.8 cm³/m²) was used, and 3M1020 (manufactured by Sumitomo 3M Limited, trade name) was used as a cushion tape. Printing was carried out for 3000 m at a printing rate of 100 m/minute.

### (Evaluation of flexographic printing plate using water-based ink)

Printing was carried out in the same manner as in (Evaluation of flexographic printing plate using solvent ink) described above except that water-based ink prepared in accordance with the following manufacturing example was used instead of the solvent ink.

The following materials were stirred for 10 minutes in a ball mill to produce ink for evaluation.
Aqueous urethane resin synthesized in accordance with the following synthesis example 42 parts by mass Urethane-acrylic composite resin WEM-202U (Taisei Fine Chemical Co,. Ltd.) 3 parts by mass
Pigment: C.I. Pigment blue 15:3 15 parts by mass Hydrocarbon-based wax W300 (Mitsui Chemicals, Inc.) 2 parts by mass
Adipic acid dihydrazide 0.2 parts by mass Ammonia water 0.2 parts by mass
Water/isopropyl alcohol (1:1) 37.6 parts by mass

### <Synthesis Example: aqueous urethane resin>

In 2000 ml four-neck flask equipped with a reflux condenser, a dropping funnel, a gas introduction tube, a stirrer, and a thermostat, placed were 57.3 parts of polytetramethylene glycol having a number average molecular weight of 2000, 20 parts of polyethylene glycol having a number average molecular weight of 2000, 13 parts of dimethylol butanoic acid, 8 parts of bis(2-hydroxypropyl)aniline, and 1.7 parts of 1,4-cyclohexanedimethanol, purged with dry nitrogen, and heated to 100°C. To the flask, 41.3 parts of isophorone diisocyanate were added dropwise over 20 minutes with stirring, and the temperature was gradually elevated to 140°C (NCO/0H = 0.98). Urethane resin was obtained through reaction for another 30 minutes. Next, 750 parts of distilled water containing 8.9 parts of 28% ammonia water were added thereto under cooling to obtain aqueous urethane resin (weight average molecular weight of about 40,000).

### <Evaluation of ink density >

The ink density of the printed matter obtained as described above was measured in SpectroEye (manufactured by SAKATA INX Corp., trade name). An average value from measurement at 7 points was regarded as the ink density. The evaluation scale for the observation results is shown below. Those given a score of 3 or more on the following evaluation scale can be practically used without any problem.

### (Evaluation scale)

5: The ink density of a solid part is 1.9 or more and 2.0 or less.
4: The ink density of a solid part is 1.8 or more and less than 1.9.
3: The ink density of a solid part is 1.6 or more and less than 1.8.
2: The ink density of a solid part is 1.4 or more and less than 1.6.
1: The ink density of a solid part is less than 1.4.

### <Tone jump>

The presence or absence of tone jump in a halftone image of the printed matter obtained as described above was visually evaluated. The evaluation scale for the observation results is shown below.

Those given a score of 3 or more on the following evaluation scale can be practically used without any problem.

### (Evaluation scale)

4: The reproducibility of a halftone image is visually smooth from a shadow part to a highlight part.
3: A boundary line against a non-image area is slightly thick at a rise of gradation, and the reproducibility of a halftone image is slightly inferior to 4.
2: A density is slightly uneven.
1: An uneven density is clearly seen.

### <Evaluation of ink adhesion>

For ink adhesion, printing was carried out in the same manner as in the printing evaluation described above except the following: since an excessive amount of ink was supplied to the photosensitive resin plate for the purpose of accelerating adhesion evaluation, the anilox pressure was increased by 0.02 mm from the proper value; and relief surface was largely deformed, and the applied pressure was increased by 0.15 mm from the proper value so as to accelerate ink adhesion.

After printing for 100 m, the anilox was detached from the photosensitive resin plate. Thereafter, printing was carried out for 10 m in no contact of the photosensitive resin plate with the anilox to remove redundant ink from the photosensitive resin plate surface. Thereafter, the printer was stopped, and evaluation was conducted in a state of ink remaining in a halftone part of the printing plate. The halftone to be evaluated was a total of 10 sites of parts with halftone areas of 3 and 30% provided in each of AM 100, 133, 150, 175, and 200 lines placed in an image. After the completion of printing, an obtained part between halftone dots (concave part) in the plate was observed with a magnifier. The evaluation scale for the observation results is shown below. Those given a score of 3 or more in the following evaluation scale can be practically used without any problem.

### (Evaluation scale)

5: No adhesion is seen in the halftones of the 10 sites.
4: The number of halftone sites having ink adhesion over 10% or more of the image area among the halftones of the 10 sites is 1 to 2.
3: The number of halftone sites having ink adhesion over 30% or more of the image area among the halftones of the 10 sites is 1 to 2.
2: The number of halftone sites having ink adhesion over 30% or more of the image area among the halftones of the 10 sites is 3 to 5.
1: The number of halftone sites having ink adhesion over 30% or more of the image area among the halftones of the 10 sites is 5 or more.

The composition of the ink absorbing layer used in each of the flexographic printing raw plates and the flexographic printing plates of Examples 1 to 19 and Comparative Examples 1 to 10, the film thickness of the ink absorbing layer, the form of the photosensitive resin composition, and the observation results described above are shown in Tables 1 and 2 below.

**[Table 1]**

| | Photosensitive resin composition layer | Ink absorbing layer | | | | | | | | |
|---|---|---|---|---|---|---|---|---|---|---|
| | | Polymer particles (b-1) | | | | | Thickening agent (b-2) | | Silicone compound (b-3) | |
| | | Name | Type | Containing butadiene | Polar group | Amount added | Type | Amount added | Type | Amount added |
| Example 1 | Form A (water) | L7430 | SBR | Yes | Carboxylic acid group | 92 | EP-10 | 3 | KF-351A | 5 |
| Example 2 | Form A (water) | A2730 | SBR | Yes | Carboxylic acid group | 92 | EP-10 | 3 | KF-351A | 5 |
| Example 3 | Form A (water) | A7141 | SBR | Yes | Carboxylic acid group | 92 | EP-10 | 3 | KF-351A | 5 |
| Example 4 | Form A (water) | A6006 | SBR | Yes | Hydroxyl group | 92 | EP-10 | 3 | KF-351A | 5 |
| Example 5 | Form A (water) | L5930 | SBR | Yes | Carboxylic acid group | 92 | EP-10 | 3 | KF-351A | 5 |
| Example 6 | Form A (water) | LACSTAR DN703 | NBR | Yes | Carboxylic acid group | 92 | EP-10 | 3 | KF-351A | 5 |
| Example 7 | Form A (water) | LACSTAR 1570B | NBR | Yes | Carboxylic acid group | 92 | EP-10 | 3 | KF-351A | 5 |
| Example 8 | Form A (water) | LACSTAR 6541G | NBR | Yes | Carboxylic acid group | 92 | EP-10 | 3 | KF-351A | 5 |
| Example 9 | Form A (water) | L7430 | SBR | Yes | Carboxylic acid group | 94 | EP-10 | 1 | KF-351A | 5 |
| Example 10 | Form A (water) | L7430 | SBR | Yes | Carboxylic acid group | 93.5 | EP-10 | 15 | KF-351A | 5 |
| Example 11 | Form A (water) | L7430 | SBR | Yes | Carboxylic acid group | 93 | EP-10 | 2 | KF-351A | 5 |
| Example 12 | Form A (water) | L7430 | SBR | Yes | Carboxylic acid group | 88 | EP-10 | 7 | KF-351A | 5 |
| Example 13 | Form A (water) | L7430 | SBR | Yes | Carboxylic acid group | 92 | EP-10 | 3 | KF-351A | 5 |
| Example 14 | Form B (solvent) | L7430 | SBR | Yes | Carboxylic acid group | 92 | EP-10 | 3 | KF-351A | 5 |
| Example 15 | Form B (solvent) | L7430 | SBR | Yes | Carboxylic acid group | 92 | EP-10 | 3 | KF-351A | 5 |
| Example 16 | Form A (water) | L7430 | SBR | Yes | Carboxylic acid group | 92 | E-60 | 3 | KF-351A | 5 |
| Example 17 | Form A (water) | L7430 | SBR | Yes | Carboxylic acid group | 92 | CP-A2H | 3 | KF-351A | 5 |
| Example 18 | Form A (water) | L7430 | SBR | Yes | Carboxylic acid group | 92 | HPMC | 3 | KF-351A | 5 |
| Example 19 | Form A (water) | L7430 | SBR | Yes | Carboxylic acid group | 92 | Xanthan Gum | 3 | KF-351A | 5 |
| Comparative Example 1 | Form A (water) | UC-3080 | Acrylic resin | Absent | Carboxylic acid group | 92 | EP-10 | 3 | KF-351A | 5 |
| Comparative Example 2 | Form A (water) | UC-3000 | Styrene acrylic resin | Absent | Carboxylic acid group | 92 | EP-10 | 3 | KF-351A | 5 |
| Comparative Example 3 | Form A (water) | VONCOAT EC-905EF | Styrene acrylic particles | Absent | Carboxylic acid group | 92 | EP-10 | 3 | KF-351A | 5 |
| Comparative Example 4 | Form B (solvent) | H1051 | SEBS | Absent | No | 92 | EP-10 | 3 | KF-351A | 5 |
| Comparative Example 5 | Form B (solvent) | KX405 | SBS | Yes | No | 92 | EP-10 | 3 | KF-351A | 5 |
| Comparative Example 6 | Form A (water) | L7430 | SBR | Yes | Carboxylic acid group | 84 | EP-10 | 11 | KF-351A | 5 |
| Comparative Example 7 | Form A (water) | L7430 | SBR | Yes | Carboxylic acid group | 80 | EP-10 | 15 | KF-351A | 5 |
| Comparative Example 8 | Form A (water) | L7430 | SBR | Yes | Carboxylic acid group | 95 | - | - | KF-351A | 5 |
| Comparative Example 9 | Form A (water) | - | - | - | - | - | - | - | - | - |
| Comparative Example 10 | Form B' (solvent) | (Ink absorbing layer of Example 37) | | | | | | | | |

**[Table 2]**

| | Development method | Ink absorbing layer | Surface free energy | | Characteristic evaluation | | Printing evaluation (solvent ink) | | |
|---|---|---|---|---|---|---|---|---|---|
| | | Film thickness (µm) | Ink absorbing layer (mJ/m²) | Photosensitive resin composition layer (mJ/m²) | Two-layer formation | Microcell | Ink density | Ink adhesion | Tone jump |
| | | | | | Observation under SEM | Concave-convex depth (µm) | | | |
| Example 1 | Water development | 30 | 38 | 35 | ○ | 7 | 4 | 4 | 3 |
| Example 2 | Water development | 30 | 38 | 35 | ○ | 7 | 4 | 4 | 3 |
| Example 3 | Water development | 30 | 38 | 35 | ○ | 7 | 4 | 4 | 3 |
| Example 4 | Water development | 30 | 35 | 35 | ○ | 7 | 4 | 4 | 3 |
| Example 5 | Water development | 30 | 38 | 35 | ○ | 7 | 4 | 4 | 3 |
| Example 6 | Water development | 30 | 38 | 35 | ○ | 7 | 4 | 4 | 3 |
| Example 7 | Water development | 30 | 38 | 35 | ○ | 7 | 4 | 4 | 3 |
| Example 8 | Water development | 30 | 35 | 35 | ○ | 7 | 4 | 4 | 3 |
| Example 9 | Water development | 5 | 38 | 35 | ○ | 1 | 3 | 5 | 3 |
| Example 10 | Water development | 10 | 38 | 35 | ○ | 5 | 4 | 4 | 3 |
| Example 11 | Water development | 20 | 38 | 35 | ○ | 7 | 4 | 4 | 3 |
| Example 12 | Water development | 45 | 38 | 35 | ○ | 7 | 5 | 3 | 3 |
| Example 13 | Solvent development | 30 | 41 | 38 | ○ | 7 | 4 | 3 | 3 |
| Example 14 | Solvent development | 30 | 35 | 32 | ○ | 7 | 4 | 3 | 3 |
| Example 15 | Heat development | 30 | 35 | 32 | ○ | 3 | 3 | 3 | 3 |
| Example 16 | Water development | 30 | 38 | 35 | ○ | 7 | 4 | 4 | 3 |
| Example 17 | Water development | 30 | 38 | 35 | ○ | 7 | 4 | 4 | 3 |
| Example 18 | Water development | 30 | 38 | 35 | ○ | 7 | 3 | 3 | 3 |
| Example 19 | Water development | 30 | 38 | 35 | ○ | 7 | 3 | 3 | 3 |
| Comparative Example 1 | Water development | - | - | 32 | × | - | 2 | 5 | 2 |
| Comparative Example 2 | Water development | - | - | 32 | × | - | 2 | 5 | 2 |
| Comparative Example 3 | Water development | - | - | 32 | × | - | 2 | 5 | 2 |
| Comparative Example 4 | Solvent development | - | - | 32 | × | - | 2 | 5 | 2 |
| Comparative Example 5 | Solvent development | - | - | 32 | × | - | 2 | 5 | 2 |
| Comparative Example 6 | Water development | 55 | 38 | 35 | ○ | 7 | 5 | 2 | 2 |
| Comparative Example 7 | Water development | 100 | 38 | 35 | ○ | 7 | 5 | 1 | 1 |
| Comparative Example 8 | Water development | 2 | 38 | 35 | ○ | 0.3 | 2 | 5 | 2 |
| Comparative Example 9 | Water development | 0 | - | 35 | - | 2 | 3 | 5 | 2 |
| Comparative Example 10 | Solvent development | 3 | 38 | 30 | ○ | 7 | 4 | 1 | 1 |

### (Component)

The following was used as each component described in the tables.

### <Polymer particles>

SB latex L7430: SB latex, manufactured by Asahi Kasei Corp.
SB latex A2730: SB latex, manufactured by Asahi Kasei Corp.
SB latex A7141: SB latex, manufactured by Asahi Kasei Corp.
SB latex A6006: SB latex, manufactured by Asahi Kasei Corp.
SB latex L5930: SB latex, manufactured by Asahi Kasei Corp.
LACSTAR DN703: butadiene resin latex, manufactured by DIC Corp.
LACSTAR 1570B: butadiene resin latex, manufactured by DIC Corp.
LACSTAR 6541G: butadiene resin latex, manufactured by DIC Corp.
ARUFON UC-3080: acrylic polymer, manufactured by Toagosei Co., Ltd.
ARUFON UC-3000: acrylic polymer, manufactured by Toagosei Co., Ltd.
VONCOAT EC-905EF: aqueous acrylic resin, manufactured by DIC Corp.
Tuftec H1051: hydrogenated styrene-based thermoplastic elastomer, manufactured by Asahi Kasei Corp.
Kraton D-KX405: styrene-butadiene block copolymer, manufactured by Kraton Corporation

### <Thickening agent>

ALKOX EP-10: ethylene oxide-propylene oxide copolymer, Meisei Chemical Works, Ltd.
HPC: hydroxypropylcellulose (Tokyo Chemical Industry Co., Ltd.)
Xanthan Gum (Tokyo Chemical Industry Co., Ltd.)
E-60: ethylene oxide homopolymer (Meisei Chemical Works, Ltd.)
CP-A2H: side chain allyl group-containing allyl glycidyl ether-ethylene oxide-propylene-oxide random copolymer (Meisei Chemical Works, Ltd.)

### <Silicone compound>

KF-351A: polyether-modified silicone oil, Shin-Etsu Chemical Co., Ltd.

**[Table 3]**

| | Photosensi tive resin compositio n layer | Ink absorbing layer | | | | | | | | | | | | | | | |
|---|---|---|---|---|---|---|---|---|---|---|---|---|---|---|---|---|---|
| | | Polymer particles (b-1) | | Thickening agent (b-2) | | Silicone (b-3) | | Binder resin (b-4) | | | | Additive, etc. | | Photopolymerization initiator (b-6) | | Polymerizable compound (b-7) | |
| | | Type | Amount added | Type | Amount added | Type | Amount added | Type | Resin chemical species | Substituent | Amount added | Type | Amount added | Type | Amount added | Type | Amount added |
| Example 20 | Form A (water) | A6006 | 92 | EP-10 | 3 | KF-351A | 5 | - | - | - | - | - | - | - | - | - | - |
| Example 21 | From A (water) | A6006 | 62 | EP-10 | 3 | KF-351A | 5 | JMR-8M | PVA resin | Hydroxyl group | 30 | - | - | - | - | - | - |
| Example 22 | Form A (water) | A6006 | 82 | EP-10 | 3 | KF-351A | 5 | JMR-8M | PVA *resin* | Hydroxyl group | 10 | - | - | - | - | - | - |
| Example 23 | Form A (water) | A6006 | 42 | EP-10 | 3 | KF-351A | 5 | JMR-8M | PVA resin | Hydroxyl group | 50 | - | - | - | - | - | - |
| Example 24 | Form A (water) | A6006 | 62 | EP-10 | 3 | KF-351A | 5 | JMR-8M | PVA resin | Hydroxyl group | 25 | MEB-3 | 5 | - | - | - | - |
| Example 25 | Form A (water) | A6006 | 62 | EP-10 | 3 | KF-351A | 5 | CP-800 | Styrene acrylic | Amino group | 30 | - | - | - | - | - | - |
| Example 26 | Form A (water) | A6006 | 62 | EP-10 | 3 | KF-351A | 5 | FZ-1000 | Styrene acrylic | Amino group | 30 | - | - | - | - | - | - |
| Example 27 | Form A (water) | A6006 | 62 | EP-10 | 3 | KF-351A | 5 | CP-7050 | Urethane structure | Amino group | 30 | - | - | - | - | - | - |
| Example 28 | Form A (water) | A6006 | 62 | EP-10 | 3 | KF-351A | 5 | AQ Nylon T-70 | Amide structure | Amino group | 30 | - | - | - | - | - | - |
| Example 29 | Form A (water) | A6006 | 82 | EP-10 | 3 | KF-351A | 5 | AQ Nylon T-70 | Amide structure | Amino group | 10 | - | - | - | - | - | - |
| Example 30 | Form A (water) | A6006 | 52 | EP-10 | 3 | KF-351A | 5 | AQ Nylon T-70 | Amide structure | Amino group | 40 | - | - | - | - | - | - |
| Example 31 | Form A (water) | A6006 | 42 | EP-10 | 3 | KF-351A | 5 | AQ Nylon T-70 | Amide structure | Amino group | 50 | - | - | - | - | - | - |
| Example 32 | Form A (water) | A6006 | 62 | EP-10 | 3 | KF-640 | 5 | AQ Nylon T-70 | Amide structure | Amino group | 30 | - | - | - | - | - | - |
| Example 33 | Form A (water) | A6006 | 62 | EP-10 | 3 | KF-352A | 5 | AQ Nylon T-70 | Amide structure | Amino *group* | 30 | - | - | - | - | - | - |
| Example 34 | Form A (water) | A6006 | 62 | EP-10 | 3 | KF-351A | 5 | AQ Nylon T-70 | Amide structure | Amino group | 25 | SU-268A | 5 | - | - | - | - |
| Example 35 | Form A (water) | A6006 | 62 | EP-10 | 3 | KF-351A | 5 | AQ Nylon T-70 | Amide structure | Amino *group* | 25 | MEB-3 | 5 | - | - | - | - |
| Example 36 | Form A (water) | A6006 | 62 | EP-10 | 3 | KF-351A | 5 | AQ Nylon A-90 | Amide structure | Amino group | 30 | - | - | - | - | - | - |
| Example 37 | Form A (water) | A6006 | 57 | EP 10 | 3 | KF-351A | 5 | - | - | - | - | - | - | Omnirad 2959 | 5 | SR399 | 30 |
| Example 36 | Form A (water) | A6006 | 77 | EP-10 | 3 | KF-351A | 5 | - | - | - | - | - | - | Omnirad 2959 | 5 | SR399 | 10 |
| Example 39 | Form A (water) | A6006 | 37 | EP-10 | 3 | KF 351A | 5 | - | - | - | - | - | - | Omnirad 2959 | 5 | SR399 | 50 |
| Example 40 | Form A (water) | A6006 | 57 | EP-10 | 3 | KF-351A | 5 | - | - | - | - | - | - | Omnirad 2959 | 5 | SR368 | 30 |
| Example 41 | Form A (water) | A6006 | 57 | EP-10 | 3 | KF-351A | 5 | - | - | - | - | - | - | Omnirad 2959 | 5 | FOM-03006 | 30 |
| Example 42 | Form A (water) | A6006 | 57 | EP-10 | 3 | KF-351A | 5 | - | - | - | - | - | - | Omnirad 2959 | 5 | CN981 | 30 |
| Example 43 | Form A (water) | A6006 | 57 | EP-10 | 3 | KF-351A | 5 | - | - | - | - | - | - | Omnirad 2959 | 5 | CN1963 | 30 |
| Example 44 | Form A (water) | A6006 | 57 | EP-10 | 3 | KF-351A | 5 | - | - | - | - | - | - | Omnirad 2959 | 5 | CN989 | 30 |
| Example 45 | Form A (water) | A6006 | 37 | EP-10 | 3 | KF-351A | 5 | AQ Nylon T-70 | Amide structure | Amino group | 25 | - | - | Omnirad 2959 | 5 | MOI-DEM | 25 |
| Comparative Example 11 | FormA (water) | - | - | - | - | - | - | - | - | - | - | - | - | - | - | - | - |
| Comparative Example 12 | Form A (water) | A6006 | 62 | EP-10 | 3 | - | - | CP 7050 | Urethane structure | Amino group | 30 | F 569 | 3 | - | - | - | - |
| Comparative Example 13 | Form A (water) | A6006 | 62 | EP-10 | 3 | - | - | CP-7050 | Urethane structure | Amino group | 30 | F 569 | 5 | - | - | - | - |
| Comparative Example 14 | Form A (water) | A6006 | 62 | EP-10 | 3 | - | - | CP-7050 | Urethane structure | Amino group | 30 | EMULGEN 350 | 3 | - | - | - | - |
| Comparative Example 15 | Form A (water) | A6006 | 62 | EP-10 | 3 | - | - | CP-7050 | Urethane structure | Amino group | 30 | EMULGEN 351 | 5 | - | - | - | - |

**[Table 4]**

| | Development method | Ink absorbing layer | Surface free energy | | Surface zeta potential | Characteristic evaluation | | Printing evaluation (aqueous ink) | | |
|---|---|---|---|---|---|---|---|---|---|---|
| | | Film thickness (µm) | Ink absorbing layer (mJ/m²) | Photosensitive resin composition layer (mJ/m²) | | Two-layer formatio n | Concave-convex depth (µm) | Ink density | Ink adhesion | Tone jump |
| Example 20 | Water development | 30 | 38.0 | 35.0 | Minus | ○ | 7 | 3 | 4 | 4 |
| Example 21 | Water development | 30 | 38.0 | 35.0 | Minus | ○ | 10 | 4 | 4 | 4 |
| Example 22 | Water development | 30 | 38.0 | 35.0 | Minus | ○ | 8 | 5 | 4 | 4 |
| Example 23 | Water development | 30 | 38.0 | 35.0 | Minus | ○ | 12 | 5 | 3 | 4 |
| Example 24 | Water development | 30 | 38.0 | 35.0 | Minus | ○ | 12 | 5 | 3 | 4 |
| Example 25 | Water development | 30 | 38.5 | 35.0 | Plus | ○ | 7 | 5 | 4 | 4 |
| Example 26 | Water development | 30 | 35.8 | 35.0 | Plus | ○ | 7 | 5 | 4 | 4 |
| Example 27 | Water development | 30 | 36.0 | 35.0 | Plus | ○ | 7 | 5 | 4 | 4 |
| Example 28 | Water development | 30 | 38.0 | 35.0 | Plus | ○ | 7 | 5 | 4 | 4 |
| Example 29 | Water development | 30 | 38.0 | 35.0 | Plus | ○ | 7 | 3 | 4 | 4 |
| Example 30 | Water development | 30 | 38.0 | 35.0 | Plus | ○ | 7 | 4 | 4 | 4 |
| Example 31 | Water development | 30 | 38.0 | 35.0 | Plus | ○ | 3 | 5 | 3 | 4 |
| Example 32 | Water development | 30 | 38.8 | 35.0 | Plus | ○ | 7 | 5 | 3 | 3 |
| Example 33 | Water development | 30 | 35.4 | 35.0 | Plus | ○ | 7 | 3 | 4 | 4 |
| Example 34 | Water development | 30 | 38.0 | 35.0 | Plus | ○ | 7 | 5 | 4 | 4 |
| Example 35 | Water development | 30 | 38.0 | 35.0 | Plus | ○ | 7 | 5 | 4 | 4 |
| Example 36 | Water development | 30 | 38.0 | 35.0 | Plus | ○ | 7 | 4 | 4 | 4 |
| Example 37 | Water development | 30 | 38.0 | 35.0 | Minus | ○ | 8 | 4 | 4 | 4 |
| Example 38 | Water development | 30 | 38.0 | 35.0 | Minus | ○ | 7 | 3 | 4 | 4 |
| Example 39 | Water development | 30 | 38.0 | 35.0 | Minus | ○ | 8 | 5 | 4 | 4 |
| Example 40 | Water development | 30 | 38.0 | 35.0 | Minus | ○ | 7 | 4 | 4 | 4 |
| Example 41 | Water development | 30 | 38.0 | 35.0 | Minus | ○ | 7 | 4 | 4 | 4 |
| Example 42 | Water development | 30 | 38.0 | 35.0 | Minus | ○ | 7 | 4 | 4 | 4 |
| Example 43 | Water development | 30 | 38.0 | 35.0 | Minus | ○ | 7 | 4 | 4 | 4 |
| Example 44 | Water development | 30 | 38.0 | 35.0 | Minus | ○ | 7 | 4 | 4 | 4 |
| Example 45 | Water development | 30 | 38.0 | 35.0 | Plus | ○ | 7 | 5 | 4 | 4 |
| Comparative Example 11 | Water development | 0 | - | 35.0 | Minus | × | × | 2 | 2 | 4 |
| Comparative Example 12 | Water development | 30 | 39.2 | 35.0 | Plus | ○ | 5 | 5 | 2 | 2 |
| Comparative Example 13 | Water development | 30 | 39.8 | 35.0 | Plus | ○ | 5 | 5 | 2 | 2 |
| Comparative Example 14 | Water development | 30 | 41 | 35.0 | Plus | ○ | 5 | 5 | 1 | 1 |
| Comparative Example 15 | Water development | 30 | 43 | 35.0 | Plus | ○ | 1 | 5 | 1 | 1 |

### (Component)

In addition to those described in Table 1 above, the following was used as each component described in the tables.
<Binder resin>
   JMR-8M: polyvinyl alcohol, manufactured by JAPAN VAM & POVAL Co., Ltd.
   CP-800: aqueous emulsion of acrylic resin (styrene methacrylic copolymer), manufactured by Harima Chemicals Group, Inc.
   DICFINE FZ-1000: styrene acrylic resin emulsion
   HYDRAN CP-7050: aqueous urethane resin, manufactured by DIC Corp.
   AQ Nylon T-70: an amine compound, an alkylene oxide compound, and a caprolactam polymer, manufactured by Toray Industries, Inc.
   AQ Nylon A-90: an amine compound and a caprolactam polymer, manufactured by Toray Industries, Inc.
   <Additive>
   SU-268A: block isocyanate, manufactured by Meisei Chemical Works, Ltd.
   MEB-3: swellable mica, Somasif MEB-3, manufactured by Katakura & Co-op Agri Corporation
   F-569: fluorine-containing additive Megaface, manufactured by DIC Corp.
   EMULGEN 350: polyoxyethylene stearyl ether, manufactured by Kao Corp.
<Photopolymerization initiator>
   Omnirad 2959: 2-hydroxy-4'-(2-hydroxyethoxy)-2-methylpropiophenone, manufactured by IGM Resins B.V.
<Polymerizable compound>
   SR399: dipentaerythritol pentaacrylate, manufactured by Arkema S.A.
   SR368: tris(2-hydroxyethyl)isocyanurate triacrylate, manufactured by Arkema S.A.
   FOM-03006: acrylamide group-containing water-soluble crosslinking agent, manufactured by FUJIFILM Corp.
   CN981: aliphatic urethane acrylate, manufactured by Arkema S.A.
   CN1963: aliphatic urethane methacrylate acrylic acid ester, manufactured by Arkema S.A.
   CN989: aliphatic urethane acrylate tripropylene glycol diacrylate, manufactured by Arkema S.A.
   Karenz MOI-DEM: block isocyanate monomer, manufactured by Showa Denko K.K.

### Industrial Applicability

The present invention has industrial applicability to a flexographic printing raw plate for obtaining a flexographic printing plate.

## Claims

1. A flexographic printing raw plate comprising at least a support, a photosensitive resin composition layer, an ink absorbing layer, and an infrared ablation layer sequentially stacked, wherein
the ink absorbing layer has a film thickness of 5 µm or more and 50 µm or less,
the ink absorbing layer comprises polymer particles containing a butadiene skeleton and having a carboxyl group and/or a hydroxy group, and/or polymer particles obtained by polymerizing a monobasic or polybasic acid monomer, and
a content of the polymer particles is 20% by mass or more and 95% by mass or less based on 100% by mass of the ink absorbing layer.

2. The flexographic printing raw plate according to claim 1, wherein
the ink absorbing layer further comprises a binder resin having a basic group.

3. The flexographic printing raw plate according to claim 2, wherein
the binder resin having a basic group comprises polyamide resin and/or polyurethane resin.

4. The flexographic printing raw plate according to any one of claims 1 to 3, wherein
the ink absorbing layer further comprises polyvinyl alcohol resin.

5. The flexographic printing raw plate according to any one of claims 1 to 4, wherein
the ink absorbing layer further comprises swellable mica.

6. The flexographic printing raw plate according to any one of claims 1 to 5, wherein
the ink absorbing layer further comprises a water-soluble photopolymerization initiator and a water-soluble polymerizable compound.

7. The flexographic printing raw plate according to claim 6, wherein
the water-soluble polymerizable compound has an amide skeleton and/or a urethane skeleton.

8. The flexographic printing raw plate according to any one of claims 1 to 7, wherein
the ink absorbing layer further comprises a water-soluble resin having an alkylene oxide chain.

9. A flexographic printing plate comprising at least a support, a photocured photosensitive resin composition layer, and an ink absorbing layer sequentially stacked, wherein
the ink absorbing layer has a film thickness of 5 µm or more and 50 µm or less, and
the ink absorbing layer comprises polymer particles containing a butadiene skeleton and having a carboxyl group and/or a hydroxy group, and/or polymer particles obtained by polymerizing a monobasic or polybasic acid monomer.

10. The flexographic printing plate according to claim 9, wherein
a difference between surface free energy of the ink absorbing layer, Ei, and surface free energy of the photocured photosensitive resin composition layer, Ep, (Ei - Ep) is larger than 0 mJ/m² and 5 mJ/m² or less.

11. The flexographic printing plate according to claim 10, wherein
the difference between surface free energy of the ink absorbing layer, Ei, and surface free energy of the photocured photosensitive resin composition layer, Ep, (Ei - Ep) is larger than 0 mJ/m² and 4 mJ/m² or less.

12. The flexographic printing plate according to claim 10, wherein
the difference between surface free energy of the ink absorbing layer, Ei, and surface free energy of the photocured photosensitive resin composition layer, Ep, (Ei - Ep) is larger than 0.5 mJ/m² and 3.5 mJ/m² or less.

13. The flexographic printing plate according to any one of claims 9 to 12, wherein
the ink absorbing layer further comprises a water-soluble polymer having an alkylene oxide chain.

14. The flexographic printing plate according to any one of claims 9 to 13, wherein
a content of the polymer particles is 20% by mass or more and 95% by mass or less based on 100% by mass of the ink absorbing layer.

15. The flexographic printing plate according to any one of claims 9 to 14, wherein
a membrane zeta potential of the ink absorbing layer is a positive value.

16. The flexographic printing plate according to any one of claims 9 to 15, wherein
the ink absorbing layer further comprises a binder resin having a basic group.

17. The flexographic printing plate according to claim 16, wherein
the binder resin having a basic group comprises polyamide resin and/or polyurethane resin.

18. The flexographic printing plate according to any one of claims 9 to 17, wherein
the ink absorbing layer further comprises polyvinyl alcohol resin.

19. The flexographic printing plate according to any one of claims 9 to 18, wherein
the ink absorbing layer further comprises swellable mica.

20. The flexographic printing plate according to any one of claims 9 to 19, wherein
the ink absorbing layer further comprises a water-soluble photopolymerization initiator and a water-soluble polymerizable compound.

21. The flexographic printing plate according to claim 20, wherein
the water-soluble polymerizable compound has an amide skeleton and/or a urethane skeleton.

22. A manufacturing method of a flexographic printing plate, comprising:
a step of producing a negative pattern by subjecting the infrared ablation layer of the flexographic printing raw plate according to any one of claims 1 to 8 to laser ablation;
a step of exposing the photosensitive resin composition layer through the ink absorbing layer; and
a step of removing an unexposed part of the photosensitive resin composition layer and the ink absorbing layer.
